# EUROPÄISCHE PATENTSCHRIFT

(11) **EP 3 355 419 B1**
(45) Veröffentlichungstag und Bekanntmachung des Hinweises auf die Patenterteilung: **27.03.2019**
(21) Anmeldenummer: 17152968.8
(22) Anmeldetag: 25.01.2017
(51) Int. Cl.: H01R 24/54, H01R 24/50, H01P 5/08, H01P 5/107

(54) **STECKVERBINDER ZUR VERBINDUNG EINES WELLENLEITERS MIT WENIGSTENS EINEM ELEKTRISCHEN LEITER**
CONNECTOR FOR CONNECTING A WAVEGUIDE WITH AT LEAST ONE ELECTRIC CONDUCTOR
CONNECTEUR ENFICHABLE DESTINÉ À RELIER UN CONDUCTEUR D'ONDE À AU MOINS UN CONDUCTEUR ÉLECTRIQUE

(43) Veröffentlichungstag der Anmeldung: 01.08.2018
(73) Patentinhaber: Rosenberger Hochfrequenztechnik GmbH & Co. KG, 83413 Fridolfing (DE)
(72) Erfinder: Zebhauser, Martin, 83410 Laufen (DE); Bippus, Rainer, 83317 Teisendorf (DE); Armbrecht, Gunnar, 84453 Mühldorf (DE); Wollitzer, Michael, 83413 Fridolfing/Pietling (DE); Klapfenberger, Raimund, 83349 Palling (DE); Westenkirchner, Florian, 84533 Haiming (DE)
(74) Vertreter: Lorenz, Markus

(56) Entgegenhaltungen:
- EP-A1- 2 988 365
- DE-A1-102005 054 233
- DE-A1-102014 218 339
- US-A1- 2014 240 062
- US-A1- 2016 164 232

## Beschreibung

Die Erfindung betrifft einen Steckverbinder zur Verbindung eines Wellenleiters mit wenigstens einem elektrischen Leiter.
Die Erfindung betrifft außerdem eine Signalverarbeitungseinheit mit einem solchen Steckverbinder und ein System zur Übertragung von hochfrequenten elektromagnetischen Signalen zwischen zwei Signalverarbeitungseinheiten.
Ein gattungsgemäßer Gegenstand ist aus der DE 10 2005 054 233 A1 bekannt.
Die Signalübertragung über herkömmliche elektrische Leiter, wie beispielsweise Kupferleiter in elektrischen Kabeln, unterliegt bei hohen Frequenzen bekanntermaßen einer starken Signaldämpfung. Somit muss, insbesondere wenn hohe Anforderungen an die Übertragungsbandbreite gestellt werden, mitunter ein hoher Aufwand betrieben werden, um die Spezifikationen zu erreichen - falls überhaupt möglich. Dies gilt besonders dann, wenn große Übertragungsdistanzen überwunden werden sollen und nur eine geringe Anzahl Datenkanäle bzw. Übertragungsleitungen zur Verfügung steht.

Eine Alternative zu einer elektrischen Signalübertragung kann eine funkbasierte Übertragung sein, d. h. eine Übertragung durch elektromagnetische Wellen. Wenn sich elektromagnetische Wellen im Raum allerdings in alle Richtungen ausbreiten, geht deren Signalleistung quadratisch mit der Distanz verloren. In einem Wellenleiter hingegen können elektromagnetische Signale idealerweise entlang nur einer Dimension verlustarm über weite Distanzen übertragen werden.

Unter einem Wellenleiter wird vorliegend eine beliebige, insbesondere lineare Struktur, verstanden, die elektromagnetische Wellen zwischen ihren Endpunkten zu führen vermag. Wellenleiter für elektromagnetische Wellen sind in der Elektrotechnik, insbesondere in der Nachrichtentechnik bzw. Hochfrequenztechnik, bereits ausreichend bekannt.

Über einen Wellenleiter können elektromagnetische Signale folglich mit verhältnismäßig geringem Aufwand über weite Strecken vergleichsweise verlustarm übertragen werden. Demnach können Wellenleiter vorteilhaft eingesetzt werden, wenn hohe Anforderungen an die Übertragungsbandbreite und/oder Übertragungsdistanz einer kabelgebundenen Kommunikation gestellt werden.

Zum weiteren Hintergrund wird auf die US 9,490,518 B1 verwiesen, die sich auf einen Wellenleiter zur Übertragung von hochfrequenten elektromagnetischen Signalen bezieht und insbesondere die Problematik einer verlustarmen Kopplung einer Antennenanordnung mit einem dielektrischen Wellenleiter beschreibt.

Obwohl die Signalübertragung über einen Wellenleiter grundsätzlich vorteilhaft ist, hat es sich in der Praxis gezeigt, dass an der Verbindungsstelle, an der das elektromagnetische Signal von einer Antennenanordnung in den Wellenleiter einkoppelt (oder umgekehrt), mitunter große Signalleistungsverluste auftreten, wenn ein Monteur nicht besondere Sorgfalt bezüglich der Ausrichtung des Wellenleiters entsprechend der Hauptabstrahlrichtung der Antennenanordnung sowie hinsichtlich Impedanzanpassungen etc. walten lässt.

In der US 9,490,518 B1 wird die Problematik z. B. anhand der Kopplung eines Wellenleiters mit einer sogenannten Vivaldi-Antenne deutlich.

In der Praxis hat sich gezeigt, dass auch bei einer sehr gewissenhaften Montage die Signalleistung nur begrenzt in den Wellenleiter eingekoppelt werden kann, da eine exakte Positionierung des Wellenleiters in Hauptabstrahlrichtung der Antenne, insbesondere bei der zeitaufwendigen Handmontage, meist nicht möglich ist. Bereits geringe Positionstoleranzen des Wellenleiters zur Antenne können zu nennenswerten Signalverlusten führen.

Die herkömmliche Montageart ist nicht zuletzt auch deshalb problematisch, da diese einen relativ hohen Platzbedarf benötigt.

Eine Möglichkeit, die Handmontage zu erleichtern und Einkopplungsverluste zu verringern, ist in der US 2015/0372388 A1 offenbart. Dabei wird ein Leiterplattensteckverbinder für einen dielektrischen Wellenleiter vorgeschlagen, mit einem Gehäuse mit einer ersten Öffnung und einer zweiten Öffnung, wobei die erste Öffnung zur Aufnahme des dielektrischen Wellenleiters ausgebildet ist und die zweite Öffnung in Richtung einer Antennenanordnung ausgerichtet ist. Der Leiterplattensteckverbinder kann am Rand einer Leiterplatte in der Nähe einer Antennenanordnung und einem Signalumsetzer angeordnet werden.

Die gattungsgemäße DE 10 2005 054 233 A1 offenbart einen als Steckverbindung verwendbaren Hohlleiterübergang für ein Füllstandradar, wobei der Hohlleiterübergang eine Mehrschicht-Leiterplatte, eine Zuleitung zum Leiten elektromagnetischer Wellen, eine Auskoppeleinheit mit einem Koppelelement und einem Resonanzraum zum Auskoppeln der elektromagnetischen Wellen aus der Zuleitung in einen Hohlleiter umfasst, wobei der Resonanzraum in der Leiterplatte integriert ist.

Der vorliegenden Erfindung liegt die Aufgabe zugrunde, einen verbesserten Steckverbinder zur Verbindung eines Wellenleiters mit wenigstens einem elektrischen Leiter bereitzustellen, bei dem insbesondere eine einfache Montage und geringe Kopplungsverluste erreichbar sind.

Der vorliegenden Erfindung liegt auch die Aufgabe zugrunde, eine verbesserte Signalverarbeitungseinheit und ein System zur Übertragung von hochfrequenten elektromagnetischen Signalen bereitzustellen.

Diese Aufgabe wird für den Steckverbinder durch die in Anspruch 1 aufgeführten Merkmale gelöst. Hinsichtlich der Signalverarbeitungseinheit wird die Aufgabe durch die Merkmale des Anspruchs 12 und bezüglich des Systems durch die Merkmale des Anspruchs 14 gelöst.

Die abhängigen Ansprüche und die nachfolgend beschriebenen Merkmale betreffen vorteilhafte Ausführungsformen und Varianten der Erfindung.

Der Steckverbinder zur Verbindung eines Wellenleiters mit wenigstens einem elektrischen Leiter umfasst ein Gehäuse zur Verbindung mit dem Wellenleiter, wobei Befestigungsmittel zur Festlegung des Gehäuses an einer Struktur, die den wenigstens einen elektrischen Leiter aufweist, vorgesehen sind. Ferner ist das Gehäuse eingerichtet, einen Signalumsetzer und eine Antennenanordnung aufzunehmen, wobei innerhalb des Gehäuses, welches hierfür eingerichtet ist, eine Wellenführungsanordnung vorgesehen ist, wobei die Wellenführungsanordnung zur Führung einer elektromagnetischen Welle in den Wellenleiter und zur Kopplung mit der Antennenanordnung angeordnet und ausgebildet ist.

Die Befestigungsmittel bzw. zumindest ein Teil der Befestigungsmittel sind vorzugsweise einstückig mit dem Gehäuse des Steckverbinders ausgebildet. Vorstellbar ist jedoch auch, dass die Befestigungsmittel durch einen Kleber oder andere bekannte Maßnahmen realisiert werden. Dies ist nachfolgend noch näher dargestellt.

Das Gehäuse kann einteilig, zweiteilig oder mehrteilig ausgebildet sein. Bevorzugt ist das Gehäuse zweiteilig ausgebildet. Vorgesehen sein kann hierzu, dass das Gehäuse einen Sockel und eine Hülse aufweist. Der Sockel ist vorzugsweise an der Struktur, zum Beispiel einer Leiterplatte bzw. einer Platine, die den wenigstens einen elektrischen Leiter aufweist, mittels der Befestigungsmittel festgelegt. Die Hülse kann mit bekannten Maßnahmen mit dem Sockel verbunden, zum Beispiel aufgepresst, verlötet oder verschweißt, werden. Der Sockel ist vorzugsweise aus Metall, zum Beispiel aus Druckguss, vorzugsweise Zink-Druckguss, ausgebildet. Die Hülse ist vorzugsweise aus Kunststoff ausgebildet.

Unter einem elektrischen Leiter wird vorliegend ein Übertragungsmedium verstanden, das eine hohe Dichte frei beweglicher Ladungsträger, beispielsweise Elektronen oder Ionen besitzt, und durch den Transport der Ladungsträger zur Übertragung von elektrischem Strom bzw. elektrischen Signalen einsetzbar ist. Als Beispiele können Metalle wie Silber, Kupfer, Aluminium und Gold oder auch andere Materialien, wie z. B. Graphit, genannt werden.

Ein solcher elektrischer Leiter kann auf oder in einer beliebigen Struktur angeordnet bzw. enthalten sein. Beispielsweise kann es sich bei einem elektrischen Leiter um einen Innenleiter und bei der Struktur um den Mantel, ein Dielektrikum und/oder die Abschirmung eines Kabels handeln. Unter einem elektrischen Leiter kann auch eine Leiterbahn auf einer Leiterplatte ("Printed Circuit Board", PCB) oder eine sonstige leitfähige Komponente einer Leiterplatte verstanden werden, wobei es sich bei der erfindungsgemäßen Struktur demnach um die Leiterplatte bzw. die Platine selbst handeln kann. Bei der erfindungsgemäßen Struktur kann es sich auch um ein Gerätegehäuse handeln.

Im Gegensatz zu einer Signalübertragung durch den Transport von Ladungsträgern findet die Signalübertragung in einem Wellenleiter durch die geführte Übertragung einer elektromagnetischen Welle durch den Wellenleiter statt.

Mit einer erfindungsgemäßen Wellenführungsanordnung ist vorliegend wenigstens ein kurzes Stück eines oder mehrerer Wellenleiterarten gemeint. Die Wellenführungsanordnung dient dazu, eine elektromagnetische Welle möglichst verlustarm in den Wellenleiter, d.h. in ein "Kabel", in dem eine elektromagnetische Wellenleitung stattfindet, einzukoppeln bzw. weiterzuführen - oder umgekehrt.

Die Wellenführungsanordnung kann vorzugsweise als Teil des Steckverbinders ausgebildet sein. Hierzu kann die Wellenführungsanordnung beispielsweise einstückig mit dem Gehäuse bzw. einem Gehäuseteil ausgebildet sein. Die Wellenführungsanordnung kann allerdings auch als von dem Steckverbinder separates Bauteil ausgebildet sein und lediglich zur Fixierung an dem Steckverbinder vorzugsweise in oder an dem Gehäuse des Steckverbinders festgelegt sein, beispielsweise durch Formschluss, Kraftschluss oder Stoffschluss. Die Verbindung erfolgt dabei vorzugsweise derart, dass die Wellenführungsanordnung nach der Verbindung ein festgelegter Bestandteil des Steckverbinders ist.

Die Wellenführungsanordnung kann mehrteilig ausgebildet sein, wobei vorgesehen sein kann, dass ein Teil der Wellenführungsanordnung aus Teilen des Gehäuses ausgebildet wird.

Erfindungsgemäß kann vorgesehen sein, dass die Wellenführungsanordnung zur Führung der elektromagnetischen Welle als Teil des Steckverbinders ausgebildet ist oder die Wellenführungsanordnung Teil des ein- oder mehrteiligen Wellenleiters ist und mit dem Gehäuse lösbar oder unlösbar verbunden ist.

Es ist somit auch möglich, die Wellenführungsanordnung durch den Wellenleiter selbst bereitzustellen. Dabei kann vorgesehen sein, dass der Wellenleiter in geeigneter Weise von dem Gehäuse aufgenommen und derart angeordnet und ausgebildet ist, dass eine geeignete Kopplung mit der Antennenanordnung erfolgt und die elektromagnetische Welle von der Antennenanordnung durch die Wellenführungsanordnung (in diesem Fall als Teil des Wellenleiters) in den Wellenleiter eingeführt bzw. weitergeführt wird.

Der Wellenleiter kann gegebenenfalls ein- oder mehrteilig ausgebildet sein. Es ist dabei insbesondere auch vorstellbar, dass bei einer mehrteiligen Ausführung des Wellenleiters gegebenenfalls außerhalb des Gehäuses weitere Verbindungen oder Verlängerungen vorgesehen sind, was sich mit bekannten Maßnahmen bewerkstelligen lässt.

Der erfindungsgemäße Steckverbinder kann vollständig mit einem Wellenleiter vorkonfektioniert sein. Eine Verbindung oder Weiterführung kann gegebenenfalls auch außerhalb des Gehäuses vorzugsweise in dem Bereich, in dem ein Wellenleiter-Stecker auf den erfindungsgemäßen Steckverbinder aufgesteckt wird, erfolgen.

Vorgesehen sein kann, dass der auf den erfindungsgemäßen Steckverbinder aufzusteckende Wellenleiter-Stecker derart gestaltet ist, dass ein Teilstück des Wellenleiters von dem Wellenleiter-Stecker, wenn dieser mit dem erfindungsgemäßen Steckverbinder verbunden ist, weitergeführt bzw. in das Gehäuses des Steckverbinders eingeführt wird. Dies kann vorzugsweise derart erfolgen, dass das vordere Ende des weitergeführten Teilstücks des Wellenleiters die Antennenanordnung kontaktiert bzw. auf dieses ausgerichtet ist, so dass eine elektromagnetische Welle eingeleitet werden kann. In diesem Fall stellt dann das weitergeführte Teilstück des Wellenleiters die Wellenführungsanordnung dar. Hierbei können geeignete Maßnahmen getroffen werden, damit das weitergeführte Teilstück des Wellenleiters, welches dann die Wellenführungsanordnung darstellt, in geeigneter Weise innerhalb des Gehäuses geführt bzw. fixiert ist.

Erfindungsgemäß kann es von Vorteil sein, wenn die Wellenführungsanordnung als Teil des Steckverbinders bzw. integral mit dem Steckverbinder ausgebildet ist.

Erfindungsgemäß ist vorgesehen, dass der Signalumsetzer mit dem wenigstens einen elektrischen Leiter verbunden ist und eingerichtet ist, um eine Wandlung zwischen elektrischen Signalen und hochfrequenten elektromagnetischen Signalen durchzuführen.

Mit elektrischen Signalen sind vorliegend digitale und/oder analoge Signale gemeint, die durch elektrischen Ladungstransport in elektrischen Leitern übertragen werden.

Unter einem hochfrequenten elektromagnetischen Signal im Sinne der Erfindung werden Signale im Bandpassbereich mit Trägerfrequenzen bzw. Mittenfrequenzen im Bereich von 10 bis 500 GHz oder mehr, vorzugsweise 50 bis 200 GHz und besonders bevorzugt 80 bis 170 GHz, beispielsweise 140 GHz, verstanden. Die verwendeten Frequenzen sind nicht beschränkend für die Erfindung.

Der Signalumsetzer kann die elektrischen Signale vom Basisband unter Verwendung bekannter Modulationstechniken in den Bandpassbereich mit beliebigen Trägerfrequenzen umsetzen.

Dadurch, dass das Gehäuse eingerichtet ist, den Signalumsetzer mit der Antennenanordnung aufzunehmen, wird die Montage auf der Struktur, also beispielsweise einer Leiterplatte, grundlegend erleichtert. Ein Wellenleiter kann schneller und einfacher mit einem elektrischen Leiter gekoppelt werden bzw. auf die Struktur geführt und/oder an diesem festgelegt werden, als dies mit dem bekannten Stand der Technik möglich ist.

Die Signalübergabe bzw. die Kopplung mit der Antennenanordnung kann an einem definierten Übergabepunkt innerhalb des Steckverbinders erfolgen. Der Steckverbinder kann deshalb bereits vorab so konfiguriert und ausgebildet sein, dass der Wellenleiter bzw. die Wellenführungsanordnung stets in Hauptabstrahlrichtung der Antennenanordnung platziert ist, wodurch die größtmögliche Signalleistung in den Wellenleiter bzw. in die Wellenführungsanordnung eingekoppelt werden kann.

Ein Monteur kann den erfindungsgemäßen Steckverbinder wie einen herkömmlichen elektrischen Steckverbinder behandeln und ohne zeitaufwendige Justierung bzw. besondere Sorgfalt in der Handhabung den Steckverbinder an einer geeigneten Stelle auf der Struktur (also z. B. an einer Leiterplatte oder einem elektrischen Kabel) platzieren und festlegen. Der Steckverbinder kann durch Standartmontagetechniken an der Struktur festgelegt werden. Dies senkt die Verarbeitungszeit bzw. Montagezeit erheblich. Ferner muss der Monteur nicht über besondere Erfahrung im Umgang mit Wellenleitern verfügen.

Die Antennenanordnung kann eine Mikrostreifenleitung und/oder einen koplanaren Wellenleiter und/oder eine koaxiale Struktur und/oder eine differenzielle Struktur umfassen bzw. entsprechend ausgebildet sein.

Es kann eine Patchantenne, Marconi-Antenne, Vivaldi-Antenne, Dipolantenne oder sonstige Bauart der Antennenanordnung vorgesehen sein. Grundsätzlich kann im Rahmen der Erfindung eine beliebige Bauart der Antennenanordnung vorgesehen sein, die der Fachmann als geeignet ansieht.

Die Antennenanordnung kann an dem Signalumsetzer festgelegt sein.

Vorzugsweise ist die Antennenanordnung Bestandteil des Signalumsetzers. Die Antennenanordnung kann auf einer Oberfläche, des Signalumsetzers, beispielsweise auf einer Oberseite, einer Seitenfläche oder einer Unterseite einer integrierten Schaltung angeordnet sein bzw. eine Hauptabstrahlcharakteristik aufweisen, die entsprechend ausgerichtet ist.

Die Antennenanordnung kann allerdings auch lediglich ortsnah zu dem Signalumsetzer angeordnet sein, beispielsweise an oder in der Struktur, die den wenigstens einen elektrischen Leiter aufweist.

Das Gehäuse kann als Kunststoffgehäuse und/oder Metallgehäuse ausgebildet sein. Vorzugsweise ist ein Metallgehäuse vorgesehen, das beispielsweise als Zink-Druckguss hergestellt ist. Besonders bevorzugt ist ein Gehäuseteil aus Metall und ein zweites Gehäuseteil aus Kunststoff ausgebildet.

Der Steckverbinder kann zur Verbindung mit einem Wellenleiter beliebiger Bauart vorgesehen sein bzw. verwendet werden, insbesondere zur Verbindung mit einem dielektrischen Wellenleiter, einem Hohlleiter oder einem Eindraht-Wellenleiter. Besonders bevorzugt ist der Steckverbinder zur Verbindung eines dielektrischen Wellenleiters mit wenigstens einem elektrischen Leiter einsetzbar.

In einer Ausgestaltung der Erfindung kann vorgesehen sein, dass der Steckverbinder als Leiterplattensteckverbinder, vorzugsweise als Leiterplattenbuchse, und die Struktur, die den wenigstens einen elektrischen Leiter aufweist, als Leiterplatte ausgebildet ist.

Unter einer Buchse wird der weibliche Teil einer Steckverbindung verstanden, der ein Gehäuse aufweist, in das der männliche Teil eines Steckverbinders eingesteckt werden kann.

Der Steckverbinder kann auch als Leiterplattenstecker ausgebildet sein.

Wenn der Steckverbinder als Leiterplattensteckverbinder ausgebildet ist, können die Befestigungsmittel des Gehäuses vorzugsweise als Metallstifte bzw. Lötstifte oder ähnliches ausgebildet sein, wodurch das Gehäuse durch ein passendes Lochraster bzw. durch passende Löcher der Leiterplatte gesteckt und beispielsweise rückseitig mit Lötflächen ("Pads") der Leiterplatte verlötet werden kann. Es ist auch eine Verschraubung oder Verklebung auf der Leiterplatte oder eine Verlötung an der Oberseite der Leiterplatte möglich (oder eine sonstige bewährte Montagetechnik).

Bei einer Ausbildung des Steckverbinders als Leiterplattensteckverbinder kann das Gehäuse des Steckverbinders ausgebildet sein, um definierte auf der Leiterplatte festgelegte elektrische Bauelemente in sich aufzunehmen bzw. zu umfassen, wenn der Steckverbinder auf der Leiterplatte festgelegt ist. Insbesondere kann vorgesehen sein, dass das Gehäuse den Signalumsetzer aufnimmt, d. h., dass der Steckverbinder bzw. das Gehäuse des Steckverbinders auf der der Leiterplatte zugewandten Seite geöffnet ist und derart über den gewünschten elektrischen Bauteilen bzw. über dem Signalumsetzer platziert und anschließend an der Leiterplatte festgelegt wird, dass sich das Bauteil bzw. der Signalumsetzer vorzugsweise vollständig innerhalb des Gehäuses befindet.

In einer alternativen Ausgestaltung der Erfindung kann der Steckverbinder als Einbaustecker oder Einbaubuchse, und die Struktur, die den wenigstens einen elektrischen Leiter aufweist, als Gerätegehäuse ausgebildet sein.

Das Gehäuse des Steckverbinders kann dann auf bekannte Weise durch Verwendung bekannter Befestigungsmittel an dem Gerätegehäuse montiert werden, beispielsweise durch Verschrauben, Vernieten, Verlöten, Verkleben oder Verklemmen.

Bei dem Gerät kann es sich beispielsweise um einen Computer, ein Steuergerät, insbesondere ein Steuergerät eines Kraftfahrzeugs, oder eine sonstige signalverarbeitende Einheit handeln.

In einer weiteren Ausgestaltung der Erfindung kann vorgesehen sein, dass der Steckverbinder als Stecker oder Kupplung, und die Struktur, die den wenigstens einen elektrischen Leiter aufweist, als Kabel, vorzugsweise als Koaxialkabel, ausgebildet sein kann.

Unter einer Kupplung wird vorliegend der weibliche Teil eines Steckverbinders verstanden, der am Ende eines Kabels, beispielsweise des Koaxialkabels, angeordnet ist.

Bei einer Ausgestaltung des Steckverbinders als Stecker oder Kupplung können die Befestigungsmittel des Gehäuses als bekannte Verbindungsmittel eines Steckverbinders zur Verbindung mit einem Kabel ausgebildet sein, beispielsweise als Klemmmittel, Klebeflächen, Pressmittel oder Lötflächen.

Vorzugsweise kann ein Dielektrikum, ein Schutzmantel, ein Außenleiter und/oder eine Abschirmung zum Zugabfang bzw. zur Befestigung des Kabels an dem Steckverbinder bzw. an dem Gehäuse des Steckverbinders verwendet werden.

Ein mit dem Steckverbinder verbundenes elektrisches Kabel kann einen oder mehrere Innenleiter aufweisen, bei denen es sich um die erfindungsgemäßen elektrischen Leiter handeln kann. Es kann eine beliebige Anzahl elektrischer Leiter in dem Kabel vorgesehen sein, beispielsweise ein Innenleiter oder auch zwei, drei, vier, fünf, sechs, sieben, acht oder mehr Innenleiter. Auch bei einem Außenleiter bzw. einer Abschirmung kann es sich um einen elektrischen Leiter im Sinne der Erfindung handeln. In dem Kabel, insbesondere in einem Koaxialkabel, kann neben einer elektrischen Signalübertragung selbstverständlich auch eine Signalübertragung durch Wellenausbreitung vorgesehen sein.

In einer weiteren alternativen Ausgestaltung der Erfindung kann der Steckverbinder als Adapter, und die Struktur, die den wenigstens einen elektrischen Leiter aufweist, als elektrischer Steckverbinder, vorzugsweise als Koaxialsteckverbinder, ausgebildet sein.

Der Steckverbinder kann somit ausgebildet sein, um einen herkömmlichen elektrischen Steckverbinder elektrisch und mechanisch zu adaptieren, um an der Verbindungsstelle von einer elektrischen Leitung bzw. elektrischen Signalführung auf eine elektromagnetische Wellensignalübertragung zu wechseln.

Bei einer Ausgestaltung des Steckverbinders als Adapter können die Befestigungsmittel des Gehäuses ausgestaltet sein, um den herkömmlichen elektrischen Steckverbinder, beispielsweise einen elektrischen Stecker, eine elektrische Buchse oder einen elektrischen Adapter, aufzunehmen und gegebenenfalls zu arretieren. Hierfür kann die sogenannte Snap-In-Technik verwendet werden. Es kann auch eine Schraubverbindung, wie beispielsweise bei D-Sub-Steckverbindern üblich, vorgesehen sein. Weiters kann auch ein Bajonettverschluss, zum Beispiel wie bei BNC-Steckverbindern, vorgesehen sein. Es können beliebige elektrische Steckverbinder adaptiert werden, wobei vorzugsweise die Befestigungstechnik(en) der jeweiligen elektrischen Steckverbinder für die Ausbildung der Befestigungsmittel des erfindungsgemäßen Steckverbinders aufgegriffen bzw. komplementär umgesetzt werden.

Das Gehäuse des Steckverbinders bzw. die Befestigungsmittel können eine mechanische Kodierung und/oder eine magnetische Kodierung durch Verwendung von Magnetkörpern bzw. Magneten aufweisen, damit der herkömmliche elektrische Steckverbinder nur in einer bestimmten Position eingesteckt werden kann.

Bei einer Ausgestaltung des Steckverbinders als Adapter kann vorgesehen sein, dass der Steckverbinder einen herkömmlichen elektrischen Steckverbinder mit einer beliebigen Anzahl elektrischer Leiter bzw. Innenleiter aufzunehmen bzw. zu adaptieren vermag.

Erfindungsgemäß ist vorgesehen, dass der Signalumsetzer als Bestandteil des Steckverbinders in dem Gehäuse festgelegt ist.

Der Signalumsetzer kann beispielsweise in dem Gehäuse verklebt, verlötet, verklemmt oder auf sonstige Weise festgelegt sein.

Insbesondere wenn der Signalumsetzer Bestandteil des Steckverbinders ist, kann ein modulares Bauteil bereitgestellt werden, das eine besondere einfache Montage ermöglicht. Beispielsweise bei einer Ausgestaltung des Steckverbinders als Leiterplattensteckverbinder kann der Steckverbinder dann mitsamt dem Signalumsetzer durch bekannte Montagetechniken auf der Leiterplatte festgelegt bzw. montiert und elektrisch verbunden werden. Die Ausrichtung der Antennenanordnung zu der Wellenführungsanordnung lässt sich durch diese Ausgestaltung optimieren. Montagefehler sind dadurch nahezu ausgeschlossen.

In einer Weiterbildung der Erfindung kann außerdem vorgesehen sein, dass der Signalumsetzer wenigstens eine integrierte Schaltung und/oder wenigstens eine Signalplatine und/oder wenigstens ein diskretes elektrisches Bauelement aufweist.

Vorzugsweise ist der Signalumsetzer als wenigstens eine integrierte Schaltung und/oder wenigstens eine Signalplatine und/oder wenigstens ein diskretes elektrisches Bauelement ausgebildet.

Bei einem elektrischen Bauelement kann es sich vorzugsweise um Widerstände, Kondensatoren, Spulen, Memristoren, Dioden oder elektrisch gesteuerte Schalter (z. B. Transistoren) handeln.

Ganz besonders bevorzugt ist der Signalumsetzer als integrierte Schaltung, beispielsweise als anwendungsspezifische integrierte Schaltung (ASIC) ausgebildet. Es können bewährte und standardisierte Signalumsetzer beliebiger Hersteller vorgesehen sein.

Anstelle einer integrierten Schaltung kann zur Implementierung des Signalumsetzers auch eine Signalplatine mit entsprechend verschalteten diskreten elektrischen Bauelementen vorgesehen sein. Auch eine Kombination aus integrierter Schaltung und diskreten elektrischen Bauelementen, die gemeinsam auf einer Signalplatine angeordnet sind, ist möglich. Der Signalumsetzer kann auch als programmierbare (digitale) Schaltung, wie z. B. als "Field Programmable Gate Array" (FPGA) oder programmierbare logische Anordnung (PLA) ausgebildet sein oder derartige Schaltungen umfassen.

Vorzugsweise ist der Signalumsetzer vollständig in dem Gehäuse des Steckverbinders aufgenommen bzw. von diesem umgeben oder sogar in dem Gehäuse eingekapselt.

In einer Weiterbildung der Erfindung kann vorgesehen sein, dass eine Versorgungsschaltung für den Signalumsetzer als Bestandteil des Steckverbinders in dem Gehäuse festgelegt ist, wobei die Versorgungsschaltung wenigstens eine integrierte Schaltung und/oder wenigstens eine Versorgungsplatine und/oder wenigstens ein diskretes elektrisches Bauelement aufweist.

Insbesondere wenn der Signalumsetzer als integrierte Schaltung ausgebildet ist oder eine integrierte Schaltung aufweist, kann eine Versorgungsschaltung erforderlich sein, beispielsweise zur Wandlung von Signalpegeln und/oder zur Bereitstellung einer stabilen Spannungsversorgung.

Es kann auch eine Signalvorverarbeitung, beispielsweise eine Analog-Digital-Wandlung oder Digital-Analog-Wandlung etc. vorgesehen sein und im Sinne der Erfindung als Versorgungsschaltung verstanden werden.

In einer Weiterbildung der Erfindung kann vorgesehen sein, dass die Wellenführungsanordnung zur Führung der elektromagnetischen Welle ein dielektrisches Wellenleiterteil und/oder ein Drahtwellenleiterteil und/oder ein Hohlleiterteil umfasst bzw. entsprechend ausgebildet ist.

Es kann von Vorteil sein, die Wellenführungsanordnung in der gleichen Bauart auszubilden, wie den Wellenleiter. D.h. wenn ein dielektrischer Wellenleiter vorgesehen ist, kann es von Vorteil sein, die Wellenführungsanordnung als dielektrisches Wellenleiterteil auszubilden; selbiges gilt analog für Drahtwellenleiterteile und Hohlleiterteile.

Es hat sich gezeigt, dass eine Wellenführung und eine Kopplung mit der Antennenanordnung bei Verwendung eines dielektrischen Wellenleiterteils bzw. bei einer Ausbildung der Wellenführungsanordnung als dielektrisches Wellenleiterteil besonders vorteilhaft und verlustarm möglich ist.

In einer Weiterbildung der Erfindung kann vorgesehen sein, dass das Gehäuse derart ausgebildet ist, dass eine Einsteckrichtung des Wellenleiters gegenüber einer Orthogonalen zu einer Auflagefläche des Gehäuses auf der Struktur um 1º bis 90º, beispielsweise 10º bis 80º, 20º bis 70º, 30º bis 60º oder 40º bis 50º, vorzugsweise 45º oder 90º, geneigt ist.

Eine Abgangsrichtung des Wellenleiters kann somit unter einem beliebigen Winkel vorgesehen sein. Vorzugsweise wird der Abgangswinkel in Abhängigkeit des verfügbaren Bauraums gewählt. Abhängig von der jeweiligen Ausgestaltung des Steckverbinders, des Wellenleiters, der Struktur und/oder der Antennenanordnung können außerdem bestimmte Abgangswinkel bevorzugt sein.

Bei einer Ausgestaltung des Steckverbinders als Leiterplattensteckverbinder können insbesondere Abgangswinkel von 45º oder 90º oder ungewinkelt ausgebildete Gehäuse vorgesehen sein. Bei einem Abgangswinkel von 90º kann der Wellenleiter anschließend seitlich von der Leiterplatte weggeführt werden und gegebenenfalls vorher über einen Teil der Platine geführt werden, wodurch beispielsweise eine (zusätzliche) mechanische Befestigung und/oder Abstützung des Wellenleiters auf der Leiterplatte möglich ist. Auch ein ungewinkeltes Gehäuse kann bei einem Steckverbinder, der als Leiterplattensteckverbinder ausgebildet ist, von Vorteil sein, da der Wellenleiter in diesem Fall orthogonal und somit platzsparend von der Leiterplatte weggeführt werden kann.

Bei einer Ausgestaltung des Steckverbinders als Einbaustecker oder Einbaubuchse können ähnliche bzw. analoge Gestaltungen vorgesehen sein.

Wenn der Steckverbinder als Stecker, Kupplung oder Adapter ausgebildet ist, wird üblicherweise eine ungewinkelte Ausgestaltung des Gehäuses bevorzugt sein, d. h. der Verlauf eines elektrischen Kabels kann von dem Wellenleiter im Wesentlichen linear fortgesetzt werden, da die Längsachsen des erfindungsgemäßen Steckverbinders und des elektrischen Steckverbinders bzw. des elektrischen Kabels im Wesentlichen zusammenfallen bzw. parallel verlaufen. Allerdings sind auch Stecker, Kupplungen und Adapter möglich, deren Abgangswinkel rechtwinklig (oder in einem sonstigen Winkel) verläuft. Die Wahl des Abgangswinkels hängt auch hier von der Einbausituation ab und kann von einem Fachmann entsprechend bestimmt werden.

Bei einer gewinkelten Ausgestaltung des Gehäuses kann vorzugsweise vorgesehen sein, dass die (innenliegende) Wellenführungsanordnung der Geometrie des Gehäuses im Wesentlichen folgt.

Es kann vorgesehen sein, dass das Gehäuse gewinkelt ausgebildet ist, um die Wellenführungsanordnung möglichst optimal zur Kopplung mit der Antennenanordnung auszurichten, ohne dass die Wellenführungsanordnung selbst gewinkelt ausgebildet ist, beispielsweise wenn eine Antennenanordnung verwendet wird, die im Wesentlichen seitlich abstrahlt.

Durch die Verwendung eines gewinkelten Gehäuses kann die Signalübertragung bzw. die Kopplung der Wellenführungsanordnung mit der Antennenanordnung situationsbezogen optimiert werden.

Das Gehäuse kann vorzugsweise so ausgeführt sein, dass die Einsteckrichtung des Wellenleiters der Hauptabstrahlrichtung der Antenne entspricht.

In einer Weiterbildung der Erfindung kann auch vorgesehen sein, dass die Wellenführungsanordnung im Gehäuse zur Ausrichtung auf eine Hauptabstrahlrichtung der Antennenanordnung gewinkelt ausgebildet ist und beispielsweise eine Biegung zwischen 1º bis 90º, 10º bis 80º, 20º bis 70º, 30º bis 60º oder 40º bis 50º, vorzugsweise von 45º oder 90º, aufweist.

Gehäuse und Wellenführungsanordnung können somit jeweils ungewinkelt oder gewinkelt ausgebildet sein, wobei jeweils ein beliebiger Winkel möglich ist.

Es sind auch mehrere Biegungen bzw. Neigungen bzw. Richtungsänderungen des Gehäuses und/oder der Wellenführungsanordnung möglich.

Die jeweilige Geometrie und die Ausrichtung des Gehäuses und der Wellenführungsanordnung zueinander sind zur Optimierung der Kopplung mit der Antennenanordnung und auf Grundlage der Einbausituation bzw. den vorhandenen Platzverhältnissen zu wählen. Üblicherweise sollte das Augenmerk darauf liegen, die Wellenführungsanordnung in Hauptabstrahlrichtung der Antennenanordnung auszurichten und diese anschließend möglichst linear weiterzuführen. Vorzugsweise sind die Wellenführungsanordnung, die Einsteckrichtung des Wellenleiters und die Hauptabstrahlrichtung der Antennenanordnung (bzw. deren Längsachsen) aufeinander ausgerichtet bzw. verlaufen parallel, beispielsweise auf einer Linie.

Wenn die Wellenführungsanordnung gewinkelt bzw. mit einer Biegung ausgebildet ist, kann eine mehrteilige Wellenführungsanordnung, beispielsweise eine Kombination aus einem dielektrischen Wellenleiterteil und einem Hohlleiterteil, von Vorteil sein, um eine möglichst verlustarme bzw. ungedämpfte Wellenführung zu ermöglichen.

Insbesondere bei Verwendung eines dielektrischen Wellenleiterteils kann an Knickstellen, Abwinklungen bzw. Biegungen des Wellenleiterteils eine Abschirmung an der Außenseite des Wellenleiterteils vorgesehen sein, beispielsweise eine Metallisierung eines äußeren Radius, um einen Signalleistungsverlust bzw. ein "Ausbrechen" der elektromagnetischen Welle aus der Führung zu vermeiden oder zumindest zu reduzieren.

In einer Weiterbildung der Erfindung kann auch vorgesehen sein, dass der Steckverbinder zur Mehrkanalübertragung und/oder zur bidirektionalen Übertragung eingerichtet ist, wobei die Wellenführungsanordnung, der Signalumsetzer und die Antennenanordnung ausgebildet sind, mehrere hochfrequente elektromagnetische Signale zu übertragen, die durch den Einsatz verschiedener Polarisation und/oder verschiedener Trägerfrequenzen und/oder definierter Übertragungszeiten und/oder räumlicher Separierung und/oder durch ein Codemultiplexverfahren unterscheidbar sind.

Wenn in dieser Beschreibung an einer Stelle die Rede von einer unidirektionalen Übertragung bzw. von einer Einkanalübertragung sein sollte oder eine solche Übertragung angedeutet wird, ist dies selbstverständlich nur beispielhaft zu verstehen und soll nur der Veranschaulichung dienen. Der Fachmann kann alle hier aufgeführten Ausführungen wahlweise für eine Einkanalübertragung oder Mehrkanalübertragung bzw. eine unidirektionale Übertragung oder eine bidirektionale Übertragung vorsehen, sofern dies nicht technisch ausgeschlossen ist.

Beispielsweise kann eine Kanal- bzw. Signalunterscheidung bzw. bidirektionale Übertragung ermöglicht werden, indem ein erstes elektromagnetisches Signal unter Verwendung einer linear polarisierten elektromagnetischen Welle und ein zweites elektromagnetisches Signal unter Verwendung einer zirkular polarisierten elektromagnetischen Welle übertragen wird.

Unter einer Mehrkanalübertragung bzw. bidirektionalen Übertragung auf Basis definierter Übertragungszeiten ist insbesondere ein Zeitmultiplexverfahren zu verstehen. Dabei werden die verschiedenen elektromagnetischen Signale sequentiell zu definierten Zeiten auf synchrone oder asynchrone Weise übertragen.

Unter einer räumlichen Separierung ist zu verstehen, dass mehrere elektromagnetische Wellen über jeweils eigene Wellenführungen bzw. Wellenkanäle (parallel) übertragen werden (analog zu einer räumlich separierten elektrischen Signalübertragung in einem elektrischen Kabel durch die Verwendung mehrerer Innenleiter). Beispielsweise kann ein mit mehreren Wellenführungen ausgestatteter dielektrischer Wellenleiter mehrere räumlich voneinander getrennte dielektrische Wellenführungen aufweisen. Um Übersprechen zwischen den Wellenführungen zu vermeiden, können die Kanäle entsprechend beabstandet sein und/oder eine zusätzliche Abschirmung zwischen den Wellenführungen vorgesehen sein.

Die Wellenführungsanordnung, der Signalumsetzer und die Antennenanordnung können demnach ausgebildet sein, derartige räumlich separierte (voneinander unabhängige) elektromagnetische Wellen zu verarbeiten. Insbesondere die Antennenanordnung und die Wellenführungsanordnung können dabei mehrteilig ausgebildet sein, um eine ideale Kopplung mit den individuellen Wellenführungen des Wellenleiters zu ermöglichen.

Der Steckverbinder kann auch zur Verbindung eines elektrischen Leiters mit mehreren Wellenleitern ausgebildet sein (analog zu einem elektrischen Steckverbinder, der mit mehreren elektrischen Kabeln verbunden wird). Das Gehäuse kann dann entsprechend zur Aufnahme mehrerer Wellenleiter ausgebildet sein. Diese Ausgestaltung ist funktional grundsätzlich ähnlich zu der Ausgestaltung mit mehreren Wellenführungen, weshalb der Fachmann die vorstehenden Merkmale auch hierfür entsprechend anpassen und anwenden kann.

In einer Weiterbildung der Erfindung kann außerdem eine elektrische Versorgung des Signalumsetzers über wenigstens einen der elektrischen Leiter vorgesehen sein, der auch wenigstens eines der elektrischen Signale überträgt.

Insbesondere bei einer Ausgestaltung des Steckverbinders als Stecker, Kupplung oder Adapter, d.h. wenn der Steckverbinder mit einem elektrischen Kabel bzw. mit einem elektrischen Steckverbinder verbunden ist und nicht direkt auf einer Leiterplatte oder in einem Gerät eingebaut ist, kann es von Vorteil sein, die Anzahl elektrischer Leiter, die zu dem Steckverbinder führen, möglichst klein zu halten, um Bauraum, Kosten und Gewicht einzusparen. In diesem Fall kann beispielsweise einer der Innenleiter zusammen mit dem Außenleiter oder einem weiteren Innenleiter des verbundenen Kabels zur elektrischen Versorgung des Signalumsetzers und/oder einer Versorgungsschaltung verwendet werden. Die entsprechenden Frequenzkomponenten der elektrischen Versorgung, beispielsweise ein Gleichwert, können im Anschluss von der Versorgungsschaltung oder dem Signalumsetzer herausgefiltert werden, um das wenigstens eine elektrische Signal in ungestörter (reiner) Form zu erhalten.

Die Versorgungsschaltung kann vorzugsweise in das Gehäuse des Steckverbinders aufgenommen bzw. Bestandteil des Steckverbinders sein.

Selbstverständlich können auf diese Weise auch mehrere elektrische Signale entsprechend moduliert und/oder zeitlich separiert über einen einzigen elektrischen Leiter übertragen werden, beispielsweise auch gemeinsam mit der elektrischen Versorgung.

Der Signalumsetzer kann dazu eingerichtet sein, mehrere elektrische Signale durch Serialisierung zu einer geringeren Anzahl hochfrequenter elektromagnetischer Signale zusammenzufassen.

Die mehreren elektrischen Signale können dem Signalumsetzer dabei insbesondere über parallele elektrische Leiter zugeführt werden. Somit kann von einer (niederfrequenten) parallelen elektrischen Signalübertragung auf eine (hochfrequente) serielle Wellensignalübertragung gewechselt werden, ohne die Datenrate zu reduzieren.

Beispielsweise kann vorgesehen sein, dass der Signalumsetzer von fünf parallelen elektrischen Leitern gespeist wird, über die jeweils mit einer Datenrate von zehn Gigabit pro Sekunde elektrische Signale übertragen werden. Der Signalumsetzer kann dann ausgebildet sein, die fünf parallelen elektrischen Signale zu serialisieren und mit einer zumindest fünfmal höheren Frequenz seriell auf elektromagnetische Weise durch den Wellenleiter mit einer Datenrate von 50 Gigabit pro Sekunde zu übertragen. Der Fachmann vermag dieses einfache Beispiel auf eine beliebige Anzahl paralleler Leiter und Datenraten zu übertragen.

Es kann vorgesehen sein, dass das Gehäuse des erfindungsgemäßen Steckverbinders elektrisch abgeschirmt ausgebildet ist und hierzu insbesondere eine metallische (bzw. leitfähige) und/oder dielektrische Abschirmung umfasst.

Auch der Wellenleiter kann eine elektromagnetische Abschirmung und/oder dielektrische Abschirmung aufweisen, um Übersprechen bzw. Signalstörungen nach und von außen zu vermeiden bzw. zu unterdrücken.

Unter einer dielektrischen Abschirmung ist zu verstehen, dass der Wellenleiter, vorzugsweise ein dielektrischer Wellenleiter und/oder die Wellenführungsanordnung und/oder das Gehäuse des Steckverbinders von einem dielektrischen Material mit niedriger Dielektrizitätszahl umgeben ist. Beispielsweise kann ein dielektrischer Wellenleiter und/oder eine dielektrische Wellenführungsanordnung eine Dielektrizitätszahl im Bereich zwischen 3 und 12 aufweisen, während eine vorteilhafte dielektrische Abschirmung eine Dielektrizitätszahl im Bereich zwischen 2 bis 5 aufweisen kann. Die Dielektrizitätszahl der Abschirmung sollte vorzugsweise kleiner sein als die Dielektrizitätszahl der Wellenführung.

Es können mehrere Abschirmungen vorgesehen sein, die kaskadiert bzw. verschachtelt, z. B. ringförmig ineinander, angeordnet sind. Dabei können die Abschirmungen auch gemischt metallisch und dielektrisch ausgebildet sein.

Die Wellenführungsanordnung und/oder die Wellenführung des Wellenleiters können aus einem Polymer, einer Keramik, Glas oder einem sonstigen geeigneten Material hergestellt sein.

Die Verbindung des Steckverbinders mit dem Wellenleiter bzw. die Verbindung der Wellenführungsanordnung mit dem Wellenleiter kann durch die Aufnahme eines Wellenleiter-Steckverbinders, d. h. durch Zusammenstecken, oder durch Direktaufnahme eines Wellenleiters, also einer Wellenleiter-Meterware, erfolgen.

Wenn ein Wellenleiter direkt in dem Steckverbinder aufgenommen werden soll bzw. mit der Wellenführungsanordnung zur Weiterführung der elektromagnetischen Welle verbunden werden soll, kann eine beliebige Verbindungsart, beispielsweise durch Formschluss, Kraftschluss oder Stoffschluss, vorgesehen sein. Beispielsweise kann eine Crimpverbindung bzw. Crimphülse zur Aufnahme des Wellenleiters vorgesehen sein. Auch ein Verklemmen, Verkleben, Verpressen oder Verschweißen des Wellenleiters mit dem Steckverbinder bzw. dem Gehäuse des Steckverbinders und/oder mit der Wellenführungsanordnung des Steckverbinders ist möglich.

Vorzugsweise kann auch ein vorkonfektioniertes Anschlusskabel ("Pigtail") zur Verbindung mit dem Steckverbinder vorgesehen sein.

Besonders bevorzugt ist der erfindungsgemäße Steckverbinder zur Verbindung mit einem Wellenleiter-Steckverbinder ausgebildet. Dabei kann vorgesehen sein, dass der erfindungsgemäße Steckverbinder ausgebildet ist, um einen Wellenleiter-Stecker aufzunehmen oder in eine Wellenleiter-Kupplung eingesteckt zu werden.

Der Wellenleiter-Steckverbinder und der erfindungsgemäße Steckverbinder können mit bekannten Maßnahmen nach dem Zusammenstecken verriegelt werden, insbesondere können Verriegelungen vorgesehen sein, die bekannt sind, um einen Stecker mit einer Buchse zu verbinden, insbesondere kann es sich hierbei um eine Verschraubung, eine Bajonettverbindung, einen Hebelmechanismus oder andere Verriegelungen handeln. Eine Verriegelung mit Hilfe einer Rastnut und einem Rasthaken kann sich hierfür gegebenenfalls in besonderer Weise eignen.

Der erfindungsgemäße Steckverbinder kann an der Verbindungsstelle mit einem Wellenleiter-Steckverbinder alle bekannten Merkmale eines Steckverbinders, wie mechanische oder magnetische Arretierung, Zugentlastung, Abschirmung, Kodierung etc. aufweisen.

Erfindungsgemäß kann vorgesehen sein, dass das Gehäuse zur Reduzierung oder Vermeidung der elektromagnetischen Abschirmung wenigstens teilweise von einer elektromagnetischen Abschirmung umgeben ist, wobei die elektromagnetische Abschirmung vorzugsweise elektrisch leitend mit einem metallischen Bereich des Gehäuses oder einem metallischen Gehäuseteil verbunden ist.

Die elektromagnetische Abschirmung soll vermeiden, dass elektromagnetische Strahlung aus dem Gehäuse bzw. dem Steckverbinder austritt, was insbesondere der Fall sein könnte, wenn der Wellenleiter unter Umständen nicht korrekt eingekoppelt wurde. Vorzugsweise umschließt die elektromagnetische Abschirmung das Gehäuse auf einer bestimmten Länge vorzugsweise vollständig und ist elektrisch mit dem Gehäuse verbunden.

In einer einfachen Ausgestaltung kann die elektromagnetische Abschirmung dadurch realisiert werden, dass das Gehäuse von einer Hülse, einer sogenannten EMV (elektromagnetische Verträglichkeit)-Hülse umgeben wird. Die Hülse kann dabei aus einem elektrisch leitenden Material, vorzugsweise Metall, ausgebildet sein.

Insofern der erfindungsgemäße Steckverbinder zur Verbindung mit einer Leiterplatte vorgesehen ist, ist es von Vorteil, wenn die elektromagnetische Abschirmung mit einem sogenannten "ground layer" der Leiterplatte oder einem Massepunkt verbunden ist. Dies lässt sich einfach dadurch erreichen, dass die elektromagnetische Abschirmung in geeigneter Weise mit einem entsprechend ausgebildeten Teilstück des Gehäuses verbunden ist. Beispielsweise kann die elektromagnetische Abschirmung mit einem aus Zink-Druckguss hergestellten Grundelement bzw. Sockel des Gehäuses verbunden sein, welches wiederum mit einem Massepunkt oder dem ground layer der Leiterplatte verbunden ist. Der Sockel des Gehäuses kann vorzugsweise den Signalumsetzer aufnehmen.

In einer vorzugsweise vorgesehenen Ausgestaltung ist das Gehäuse zwei- oder mehrteilig ausgebildet. Dabei ist ein Sockel des Gehäuses vorzugsweise elektrisch leitend, vorzugsweise aus Metall, zum Beispiel aus einem Druckguss, insbesondere einem Zink-Druckguss, gebildet. Ein Teil oder weitere Teile des Gehäuses können aus einem elektrisch nicht leitenden Material, zum Beispiel einem Kunststoff, ausgebildet sein. Die elektromagnetische Abschirmung eignet sich in besonderer Weise für die aus Kunststoff bzw. einem nicht elektrisch leitenden Material gebildeten Gehäuseteile. Dabei kann die elektromagnetische Abschirmung vorzugsweise mit dem elektrisch leitenden Gehäuseteil, zum Beispiel dem Sockel, verbunden sein, um eine durchgängige Abschirmung bereitzustellen. Eine derartige Anordnung eignet sich für alle Ausführungsformen. Die elektromagnetische Abschirmung kann auch dadurch erreicht werden, dass das Gehäuse wenigstens teilweise, vorzugsweise vollständig, insbesondere in den Bereichen, in denen das Gehäuse bzw. die Gehäuseteile nicht metallisch ausgebildet ist bzw. sind, metallisch beschichtet ist. Dies kann beispielsweise durch Aufdampfen erfolgen. Dabei kann wiederum vorgesehen sein, dass eine elektrische Verbindung zu einem metallischen Teil des Gehäuses und/oder dem ground layer und/oder einem Massepunkt hergestellt wird. Ferner ist es grundsätzlich auch möglich, eine Metallfolie in geeigneter Weise auf das Gehäuse, insbesondere die elektromagnetisch nicht abgeschirmten Gehäuseteile, aufzubringen.

Eine elektromagnetische Abschirmung kann vorzugsweise auch dadurch realisiert werden, dass ein Stecker des Wellenleiters bzw. ein Kabelstecker, der mit dem Gehäuse des erfindungsgemäßen Steckverbinders in bekannter Weise verbunden wird, mit einer elektromagnetischen Abschirmung derart ausgebildet ist, dass das Gehäuse des erfindungsgemäßen Steckverbinders wenigstens teilweise elektromagnetisch abgeschirmt ist, wenn der Wellenleiter-Stecker mit dem erfindungsgemäßen Steckverbinder verbunden ist. Eine leitende Verbindung zu einem Massepunkt bzw. dem ground layer bzw. zu einem Teil des Gehäuses, welches metallisch ausgebildet ist, kann durch bekannte Maßnahmen, beispielsweise über Kontaktfedern, erfolgen.

Die Erfindung betrifft auch eine Signalverarbeitungseinheit mit einem Steckverbinder gemäß den vorstehenden Ausführungen und mit einer Struktur, die wenigstens einen elektrischen Leiter aufweist.

Unter einer Signalverarbeitungseinheit ist vorliegend eine elektrische Komponente wie beispielsweise ein Computer, ein Steuergerät, insbesondere ein Steuergerät in einem Kraftfahrzeug, oder eine beliebige weitere Recheneinheit zu verstehen. Häufig weist eine derartige Signalverarbeitungseinheit wenigstens eine Leiterplatte, eine elektrische Kabelverbindung bzw. ein elektrisches Kabel und/oder einen elektrischen Steckverbinder auf.

In einer Weiterbildung der Signalverarbeitungseinheit kann vorgesehen sein, dass ein Signalumsetzer auf der Struktur festgelegt ist und in einem Gehäuse des Steckverbinders aufgenommen ist, wenn der Steckverbinder auf der Struktur festgelegt ist. Alternativ kann der Signalumsetzer auch in das Gehäuse integriert sein.

Die Erfindung betrifft ferner ein System zur Übertragung von hochfrequenten elektromagnetischen Signalen, umfassend
- eine erste Signalverarbeitungseinheit gemäß der vorstehenden Beschreibung,
- eine zweite Signalverarbeitungseinheit mit einem zweiten Steckverbinder, und
- einen Wellenleiter,
wobei wenigstens ein hochfrequentes elektromagnetisches Signal zwischen den beiden Signalverarbeitungseinheiten über den Wellenleiter übertragbar ist.

Bei der zweiten Signalverarbeitungseinheit kann es sich um eine beliebige Signalverarbeitungseinheit handeln. Vorzugsweise ist die zweite Signalverarbeitungseinheit allerdings auch mit vorstehend beschriebenen Merkmalen, d. h. insbesondere dem erfindungsgemäßen Steckverbinder, ausgestattet.

Merkmale und Vorteile, die bezüglich des Steckverbinders bereits beschrieben wurden, können auch auf die Signalverarbeitungseinheit und das System übertragen werden - und umgekehrt. Die Beschreibung der Erfindung ist entsprechend zu verstehen.

Das erfindungsgemäße System eignet sich zur hochfrequenten Signalübertragung bzw. zur Signalübertragung mit hohen Datenraten innerhalb der gesamten Elektrotechnik bzw. Nachrichtentechnik.

Beispielsweise können Signale zwischen zwei Leiterplatten und/oder Signale zwischen zwei Signalverarbeitungseinheiten, beispielsweise zwei Computern oder zwei Steuergeräten, übertragen werden.

Die Signalübertragung durch den Wellenleiter kann über kurze Distanzen oder lange Distanzen vorgesehen sein. Die elektromagnetischen Signale durch den Wellenleiter können bereits über Distanzen übertragen werden, die kleiner als 10 cm aber auch größer als 100 m sind. Vorzugsweise werden die elektromagnetischen Signale durch den Wellenleiter über eine Länge von 10 cm bis 100 m, beispielsweise über eine Distanz > 50 cm, > 1 m, > 2 m, > 3 m, > 4 m, > 5 m, > 10 m, > 20 m, > 30 m, > 40 m oder > 50 m übertragen.

Die Übertragung durch den Wellenleiter kann durch weitere Steckverbinder unterbrochen sein. Das heißt es kann auch vorgesehen sein, dass zur Verlängerung eines Wellenleiters innerhalb des Systems mehrere Wellenleiter durch Verwendung von Steckverbinder zusammengefügt werden.

Der erfindungsgemäße Steckverbinder, die erfindungsgemäße Signalverarbeitungseinheit und das erfindungsgemäße System lassen sich vorteilhaft innerhalb der gesamten Elektrotechnik einsetzen. Ein besonders bevorzugtes Anwendungsgebiet betrifft dabei die Raumfahrttechnik sowie die Fahrzeugtechnik (Landfahrzeuge, Wasserfahrzeuge und Luftfahrzeuge). Besonders bevorzugt können hochfrequente elektromagnetische Signale mit hohen Datenraten zwischen Steuergeräten von Fahrzeugen, beispielsweise Kraftfahrzeugen, übertragen werden.

Bei dem Wellenleiter kann es sich um einen beliebigen, bekannten Wellenleiter handeln. Der erfindungsgemäße Steckverbinder eignet sich für alle bekannten Wellenleiter.

Ein dielektrisches Wellenleiterteil und/oder eine dielektrische Wellenführung des Wellenleiters können einen rechteckigen, quadratischen, trapezförmigen, zylindrischen, ovalen oder beliebigen sonstigen Querschnitt aufweisen.

Der Querschnitt einer dielektrischen Wellenführung bzw. des dielektrischen Wellenleiterteils kann sich über die Länge des dielektrischen Wellenleiters bzw. des dielektrischen Wellenleiterteils verändern, beispielsweise um eine Impedanzanpassung vorzunehmen.

Nachfolgend werden Ausführungsbeispiele der Erfindung anhand der Zeichnung näher beschrieben.

Die Figuren zeigen jeweils bevorzugte Ausführungsbeispiele, in denen einzelne Merkmale der vorliegenden Erfindung in Kombination miteinander dargestellt sind. Merkmale eines Ausführungsbeispiels sind auch losgelöst von den anderen Merkmalen des gleichen Ausführungsbeispiels umsetzbar und können dementsprechend von einem Fachmann ohne Weiteres zu weiteren sinnvollen Kombinationen und Unterkombinationen mit Merkmalen anderer Ausführungsbeispiele verbunden werden.

In den Figuren sind funktionsgleiche Elemente mit denselben Bezugszeichen versehen.

Es zeigen schematisch:
- Figur 1: eine erste Ausführung des erfindungsgemäßen Steckverbinders als Leiterplattenbuchse mit einem geraden Abgang des Gehäuses in einer geschnitten isometrischen Darstellung;
- Figur 2: eine zweite Ausführung des erfindungsgemäßen Steckverbinders als Leiterplattenbuchse mit einem gewinkelten Abgang des Gehäuses in einer geschnitten isometrischen Darstellung;
- Figur 3: eine dritte Ausführung des erfindungsgemäßen Steckverbinders als Leiterplattenbuchse mit einem geraden Abgang des Gehäuses in einer geschnittenen isometrischen Darstellung;
- Figur 4: eine vierte Ausführung des erfindungsgemäßen Steckverbinders als Leiterplattenbuchse mit einem gewinkelten Abgang des Gehäuses in einer Seitenansicht;
- Figur 5: eine Ausführung des erfindungsgemäßen Steckverbinders als Kupplung in einer Schnittdarstellung;

- Figur 6: eine Ausführung des erfindungsgemäßen Steckverbinders als Adapter in einer Schnittdarstellung;
- Figur 7: ein erfindungsgemäßes System mit zwei Signalverarbeitungseinheiten und einem Wellenleiter;
- Figur 8: einen Wellenleiter in einer Ausführungsform mit zwei Wellenführungen; und
- Figur 9: einen Wellenleiter in einer weiteren Ausführungsform.

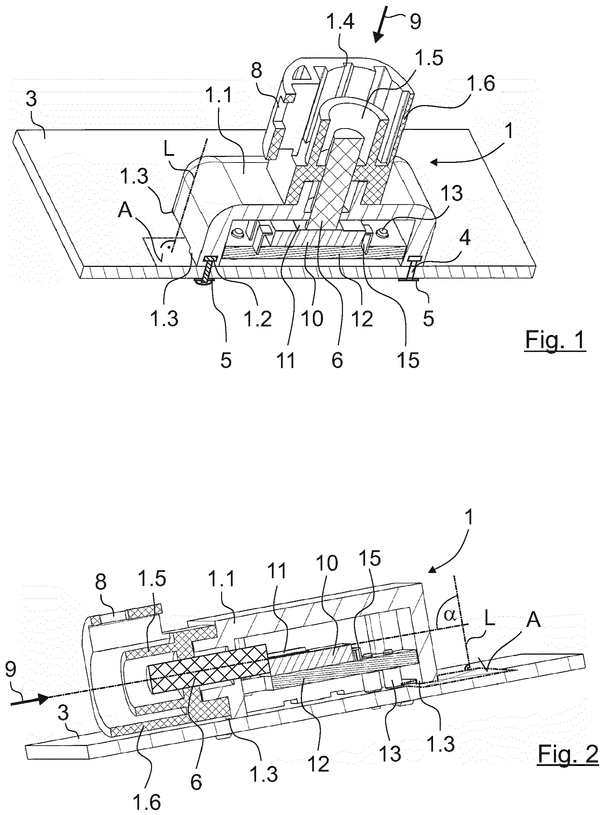

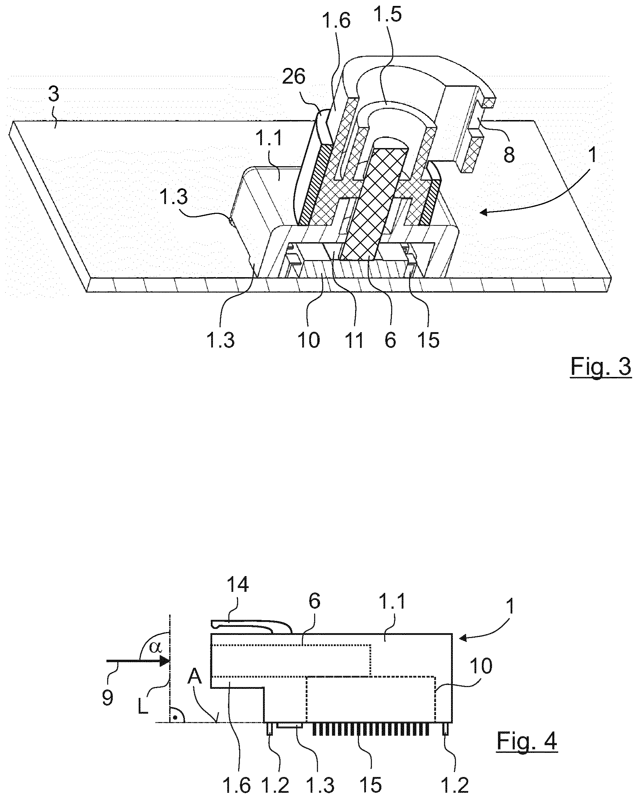

Die Ausführungsbeispiele nach den Figuren 1, 2, 5 und 6 zeigen erfindungsgemäße Steckverbinder mit einer sogenannten aktiven Lösung zur Signalverarbeitung. Die Ausführungsbeispiele nach den Figuren 3 und 4 zeigen erfindungsgemäße Steckverbinder mit einer sogenannten passiven Lösung zur Signalverarbeitung.

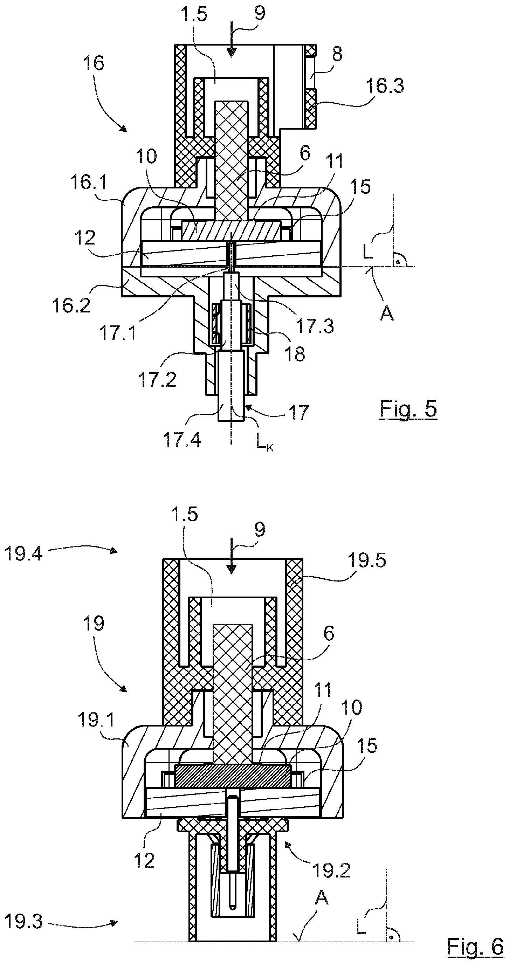

Die erfindungsgemäßen Steckverbinder dienen in allen Ausführungsformen dazu, einen Wellenleiter 2, insbesondere ein Wellenleiterkabel, mit wenigstens einem elektrischen Leiter zu verbinden, wobei die zu verbindenden elektrischen Leiter aus Übersichtlichkeitsgründen lediglich in der Figur 5 dargestellt sind. Dem Fachmann ist allerdings geläufig, wie entsprechende elektrische Leiter in den anderen Ausführungsformen realisiert sind.

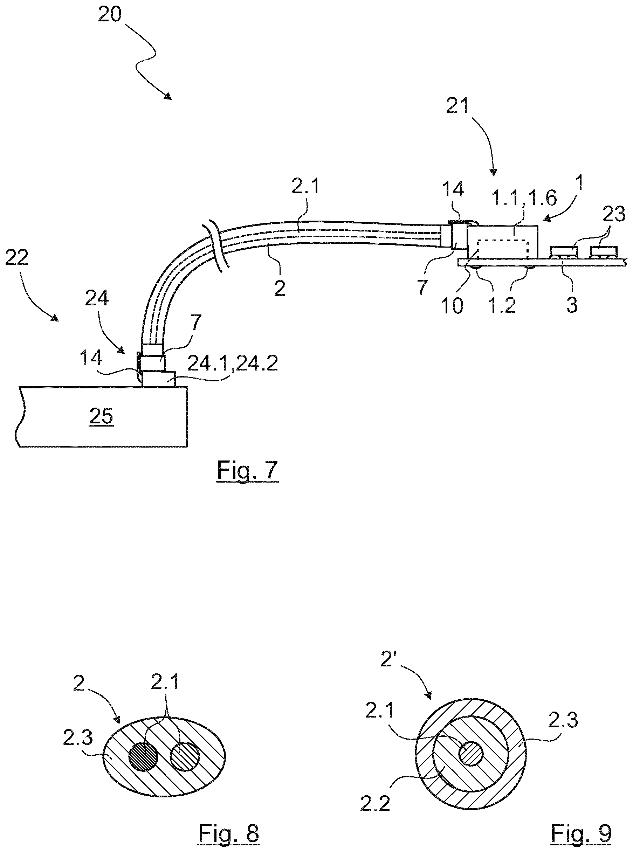

In Figur 1 ist eine erste Ausführung eines erfindungsgemäßen Steckverbinders 1 in geschnittener isometrischer Darstellung gezeigt. Der Steckverbinder ist dabei als Leiterplattenbuchse 1 ausgebildet und zur Verbindung eines Wellenleiters 2 (vgl. Figur 7) mit einem elektrischen Leiter (nicht dargestellt) einer Leiterplatte 3 vorgesehen.

Die Leiterplattenbuchse 1 weist ein zweiteiliges Gehäuse auf, welches sich aus einem Sockel 1.1 und einer Hülse 1.6 zusammensetzt. Es kann alternativ auch ein einteiliges Gehäuse, insbesondere aus Metall und/oder Kunststoff, oder ein mehrteiliges Gehäuse vorgesehen sein. Alle Ausführungsbeispiele sind entsprechend zu verstehen.

Im Ausführungsbeispiel ist vorgesehen, dass der Sockel 1.1 und die Hülse 1.6 unlösbar miteinander verbunden sind, beispielsweise durch Einpressen, Verschrauben, Verlöten oder Verschweißen der Hülse 1.6 mit dem Sockel 1.1.

Der Sockel 1.1 ist vorzugsweise aus einem elektrisch leitenden Material, vorzugsweise Metall, besonders bevorzugt einem Druckguss und ganz besonders bevorzugt einem Zink-Druckguss, ausgebildet. Der Sockel 1.1 kann in bekannter Weise auch als Außenleiter dienen. In den Ausführungsbeispielen ist dies jedoch nicht vorgesehen. Die Hülse 1.6 ist vorzugsweise aus einem elektrisch nicht leitenden Material bzw. einem Kunststoff ausgebildet. Die Erfindung ist nicht darauf beschränkt, dass der Sockel 1.1 und die Hülse 1.6 aus bestimmten Materialien ausgebildet sind. Die vorgenannte Ausgestaltung eignet sich jedoch in besonderer Weise und ist vorzugsweise für alle Ausführungsformen entsprechend vorgesehen.

Die Beschreibung der Ausführungsbeispiele ist grundsätzlich derart zu verstehen, dass anstelle des dargestellten zweiteiligen Gehäuses 1.1, 1.6 auch ein einteiliges oder mehrteiliges Gehäuse Verwendung finden kann. In diesem Fall sind dann die Merkmale, die bezüglich des Sockels 1.1 bzw. der Hülse 1.6 dargestellt sind und die gemeinsam als Gehäuse bezeichnet werden, entsprechend analog auf ein einteiliges Gehäuse oder ein mehrteiliges Gehäuse umzudeuten. Insbesondere kann in diesem Fall das Merkmal Sockel 1.1 und/oder das Merkmal Hülse 1.6 durch das Merkmal Gehäuse ersetzt werden.

Der Sockel 1.1 umfasst Befestigungsmittel 1.2 zur Festlegung an der Leiterplatte 3, bei denen es sich in der in Figur 1 dargestellten Ausführungsform um Metallstifte 1.2 handelt, die durch entsprechende Löcher 4 der Leiterplatte 3 hindurchgesteckt und rückseitig durch Verlöten auf entsprechenden Lötflächen 5 festgelegt werden können.

Zur besseren Darstellung ist in Figur 1 nur einer der Metallstifte 1.2 in der Leiterplattenbuchse 1 abgebildet, wodurch eines der Löcher 4 der Leiterplatte 3 besser erkennbar ist.

Es können beliebige (weitere) Befestigungsmittel vorgesehen sein. Beispielsweise kann der Sockel 1.1 der Leiterplattenbuchse 1 auch an der Oberseite der Leiterplatte 3 verklebt werden.

Geeignete bzw. entsprechende Befestigungsmittel 1.2 zur Festlegung des Sockels 1.1 sind auch in den Ausführungsformen nach den Figuren 2 bis 4 (in den Figuren 2 und 3 nicht exemplarisch dargestellt) vorgesehen.

Es können Distanzmittel 1.3 vorgesehen sein, um den Sockel 1.1 zumindest teilweise von der Leiterplatte 3 zu distanzieren bzw. um die Auflagefläche A des Sockels 1.1 auf der Leiterplatte 3 zu verkleinern. Dadurch können Luftspalte zwischen dem Sockel 1.1 und der Leiterplatte 3 entstehen, die beispielsweise der Kühlung des Innenraums des Sockels 1.1 bzw. der Hülse 1.6 dienen und/oder eine unerwünschte Berührung bzw. Kontaktierung von Leiterbahnen der Leiterplatte 3 verhindern. Die Distanzmittel 1.3 können in der Art von Stegen aus dem Sockel 1.1 herausgearbeitet sein. Die Distanzmittel 1.3 und/oder die Befestigungsmittel 1.2 können auch dazu dienen, eine elektrische Verbindung zwischen dem Sockel 1.1 und der Leiterplatte 3, insbesondere einem "ground layer" bzw. einem Massepunkt der Leiterplatte 3, herzustellen.

Der Sockel 1.1 umfasst weiter eine Wellenführungsanordnung 6 zur Führung einer elektromagnetischen Welle in den Wellenleiter 2. Die Wellenführungsanordnung 6 ist im Ausführungsbeispiel als dielektrisches Wellenleiterteil ausgebildet. Es kann allerdings auch ein Drahtwellenleiterteil oder ein Hohlleiterteil oder eine Kombinationen hieraus vorgesehen sein. Die Ausführungsbeispiele sind entsprechend zu verstehen.

In den Ausführungsbeispielen ist vorgesehen, dass die Wellenführungsanordnung 6 als Bestandteil des Steckverbinders ausgebildet ist. Alternativ dazu kann die Wellenführungsanordnung 6 jedoch auch Teil eines ein- oder mehrteiligen Wellenleiters 2, 2' sein und mit dem Gehäuse lösbar oder unlösbar verbunden sein. Die Wellenführungsanordnung 6 kann gegebenenfalls auch in einem nachfolgend noch näher dargestellten Wellenleiter-Stecker 7 ausgebildet sein bzw. der Wellenleiter-Stecker 7 kann ein Teilstück des Wellenleiters 2 derart weiterführen, dass, wenn der Wellenleiter-Stecker 7 mit dem erfindungsgemäßen Steckverbinder verbunden ist, ein Teilstück des Wellenleiters 2 in das Gehäuse eindringt.

Bei der Wellenführungsanordnung 6 muss es sich somit nicht zwingend um einen Teil des Steckverbinders handeln. Die Wellenführungsanordnung 6 kann auch durch den Wellenleiter 2, 2' bereitgestellt werden. Alle Ausführungsbeispiele sind derart zu verstehen, dass die Wellenführungsanordnung 6 als Teil des Steckverbinders ausgebildet sein kann, aber auch durch den Wellenleiter 2, 2' bereitgestellt sein kann.

Die Leiterplattenbuchse 1 bzw. insbesondere die Hülse 1.6 der Leiterplattenbuchse 1 ist ausgebildet, um eine Verbindung mit einem Wellenleiter-Stecker 7 (vgl. Figur 7) herzustellen. Die spezifische Geometrie der Hülse 1.6 und gegebenenfalls des Sockels 1.1 ist dabei an den entsprechenden Wellenleiter-Stecker 7 angepasst, um diesen in sich aufzunehmen und/oder um ein Aufstecken des Wellenleiter-Steckers 7 zu ermöglichen. Das Gehäuse, insbesondere die Hülse 1.6 des Gehäuses, ist hierzu vorzugsweise mechanisch und/oder magnetisch kodiert, wodurch nur ein bestimmter Wellenleiter-Stecker 7 und auch nur in einer bestimmten Orientierung eingesteckt werden kann. Es können auch Führungsschienen und/oder Führungsnuten 1.4 an der Hülse 1.6 vorgesehen sein. Die Hülse 1.6 weist ferner eine Rastnut 8 auf, in die ein Rasthaken eines Wellenleiter-Steckers 7 einrasten kann. Die Wellenführungsanordnung 6 bzw. das dielektrische Wellenleiterteil ist dabei derart ausgerichtet, dass es die geführte elektromagnetische Welle mit möglichst geringen Signalleistungsverlusten direkt in den Wellenleiter 2 bzw. den Wellenleiter-Stecker 7 bzw. eine Wellenführung des Wellenleiters 2 bzw. des Wellenleiter-Steckers 7 weiterzugeben vermag.

Das aus dem Sockel 1.1 und der Hülse 1.6 ausgebildete Gehäuse ist in der Ausführungsform nach Figur 1 ungewinkelt ausgebildet bzw. weist eine gerade Abgangsrichtung auf. Die Einsteckrichtung des Wellenleiter-Steckers 7, in den Figuren als Pfeil 9 gekennzeichnet, verläuft dabei parallel zu einer Orthogonalen L zu der Auflagefläche A des Sockels 1.1 auf der Leiterplatte 3.

Die Wellenführungsanordnung 6 in der Ausführungsform nach Figur 1 verläuft linear bzw. geradlinig durch den Sockel 1.1 und die Hülse 1.6.

Das Gehäuse, in den Ausführungsbeispielen der Sockel 1.1, ist weiter dazu eingerichtet, einen Signalumsetzer 10 mit einer Antennenanordnung 11 aufzunehmen. Der Signalumsetzer 10 ist dabei als Bestandteil der Leiterplattenbuchse 1 vorzugsweise mittelbar in dem Sockel 1.1 festgelegt bzw. Bestandteil der Leiterplattenbuchse 1. Der Signalumsetzer 10 kann auch an einer anderen Stelle des Gehäuses angeordnet sein.

In der Ausführung der Figur 1 ist die Antennenanordnung 11 Bestandteil des Signalumsetzers 10 und auf der Oberseite des Signalumsetzers 10 angeordnet, wobei die Hauptabstrahlrichtung der Antennenanordnung 11 auf die Wellenführungsanordnung 6 ausgerichtet ist. Demnach ist die Wellenführungsanordnung 6 im Gehäuses zur optimalen Kopplung mit der Antennenanordnung 11 angeordnet und ausgebildet.

Der Signalumsetzer 10 ist im Ausführungsbeispiel als anwendungsspezifische integrierte Schaltung ausgebildet. Grundsätzlich kann der Signalumsetzer 10 wenigstens eine integrierte Schaltung und/oder wenigstens eine Signalplatine und/oder wenigstens ein diskretes elektrisches Bauteil aufweisen. Der Signalumsetzer 10 ist mit dem wenigstens einen elektrischen Leiter auf der Leiterplatte 3 verbunden und eingerichtet, um eine Wandlung zwischen elektrischen Signalen und hochfrequenten elektromagnetischen Signalen durchzuführen.

In der Ausführung der Figur 1 ist eine Versorgungsschaltung 12 für den Signalumsetzer 10 als Bestandteil der Leiterplattenbuchse 1 in dem Sockel 1.1 festgelegt. Alternativ ist auch eine Anordnung an einer beliebigen anderen Stelle des Gehäuses, in den Ausführungsbeispielen also auch in der Hülse 1.6, möglich. Die Versorgungsschaltung 12 weist vorzugsweise eine Versorgungsplatine und mehrere diskrete elektrische Bauelemente (nicht dargestellt) auf. Die Versorgungsschaltung 12 ist im Ausführungsbeispiel mit dem Sockel 1.1 verbunden, beispielsweise verklemmt oder verklebt und weist elektrische Verbindungen 13 zu der Leiterplatte 3 und somit zu dem wenigstens einen elektrischen Leiter auf. Dadurch, dass der Signalumsetzer 10 auf der Versorgungsschaltung 12 festgelegt und elektrisch mit der Versorgungsschaltung 12 verbunden ist, ist der Signalumsetzer 10 somit auch an dem Sockel 1.1 der Leiterplattenbuchse 1 festgelegt. Über die elektrische Verbindung mit der Versorgungsschaltung 12, wozu elektrische Kontakte 15 vorgesehen sein können, ist der Signalumsetzer 10 ferner mit dem wenigstens einen elektrischen Leiter der Leiterplatte 3 elektrisch verbunden.

Durch die elektrischen Verbindungen 13 ist die Versorgungsschaltung 12 außerdem an der Leiterplatte 3 festgelegt. Es kann sich bei der elektrischen Verbindung also gleichzeitig um Befestigungsmittel der Versorgungsschaltung 12 handeln. Die elektrischen Verbindungen 13 bzw. Befestigungsmittel der Versorgungsschaltung 12 können auch als Abstandsmittel der Versorgungsschaltung 12 verwendet werden.

Auch wenn dies im Ausführungsbeispiel nicht dargestellt ist, können die Wellenführungsanordnung 6 und die Antennenanordnung 11 jeweils auch mehrteilig ausgebildet sein, um mehrere räumlich separierte elektromagnetische Signale zu führen. Die Leiterplattenbuchse 1 kann auch zur Verbindung mit mehreren Wellenleitern 2 bzw. mit einem Wellenleiter 2 mit mehreren Wellenführungen 2.1 (vgl. Figur 8) vorgesehen sein.

Grundsätzlich kann der Steckverbinder bzw. die Leiterplattenbuchse 1 also zur Mehrkanalübertragung und/oder zur bidirektionalen Übertragung eingerichtet sein. Dabei können mehrere hochfrequente elektromagnetische Signale übertragen werden, beispielsweise durch den Einsatz verschiedener Polarisation und/oder verschiedener Trägerfrequenzen und/oder definierter Übertragungszeiten.

Es kann eine metallische und/oder dielektrische Abschirmung 1.5 vorgesehen sein, die beispielsweise durch den Sockel 1.1 und/oder die Hülse 1.6 ausgebildet ist. Die Abschirmung 1.5 kann ringförmig um die Wellenführungsanordnung 6 verlaufen und sich über deren Länge oder darüber hinaus erstrecken.

In Figur 2 ist eine Ausführung der Erfindung dargestellt, die der Ausführungsform der Figur 1 grundsätzlich ähnlich ist, vorliegend aber eine Leiterplattenbuchse 1 zeigt, bei der das Gehäuse einen gewinkelten Abgang aufweist. Auf eine erneute Beschreibung identischer oder grundsätzlich ähnlicher Komponenten wird dabei nachfolgend, soweit möglich, verzichtet. Alle Merkmale, die bezüglich der Figur 1 beschrieben wurden, können auch bei allen anderen Ausführungsbeispielen umgesetzt werden, ohne dass es hierzu einer expliziten Erwähnung bedarf. Im Folgenden wird im Wesentlichen auf die Unterschiede im Detail eingegangen; dies gilt auch für nachfolgende Figuren.

Im Gegensatz zur Ausführung der Figur 1 sind der Sockel 1.1 und die Hülse 1.6 der Ausführung der Figur 2 gestaltet, um einen Winkel α zwischen der Einsteckrichtung 9 (bzw. deren Verlängerung) und einer Orthogonalen L zu der Auflagefläche A des Sockels 1.1 auf der Leiterplatte 3 auszubilden. Im Ausführungsbeispiel nach der Figur 2 beträgt der Winkel α vorzugsweise 90°. Es kann grundsätzlich ein beliebiger Winkel α vorgesehen sein.

Ein Gehäuse 1.1, 1.6 mit einer gewinkelten Abgangsrichtung kann aus mehreren Gründen von Vorteil sein. Zunächst können geometrische Beschränkungen bzw. Vorgaben eine entsprechende Abgangsrichtung vorgeben. Schließlich kann es auch von Vorteil sein, den Wellenleiter 2 zunächst flach auf der Leiterplatte 3 weiterzuführen, wodurch der Wellenleiter 2 zusätzlich gestützt und/oder fixiert werden kann. Nicht zuletzt kann es von Vorteil sein darauf zu achten, die Wellenführungsanordnung 6 in eine Hauptabstrahlrichtung der Antennenanordnung 11 auszurichten und so die bestmögliche Kopplung zu erzielen.

In der Ausführung der Figur 2 verläuft die Hauptabstrahlrichtung der Antennenanordnung 11 seitlich von dem Signalumsetzer 10 weg. Dadurch, dass das Gehäuse 1.1, 1.6 um 90º gewinkelt ausgebildet ist, kann die Wellenführungsanordnung 6 aber dennoch linear verlaufen. Ein linearer Verlauf der Wellenführungsanordnung 6 ist vorzuziehen, da hierdurch im Optimalfall keine Dämpfung auftritt bzw. keine Signalleistungsverluste auftreten. Die Hauptabstrahlrichtung der Antennenanordnung 11 verläuft somit entgegen die Einsteckrichtung 9 entlang der Längsachse der Wellenführung 6.

Alternativ kann auch vorgesehen sein, dass das Gehäuse 1.1, 1.6 ungewinkelt ausgebildet ist, wobei die Wellenführungsanordnung 6 eine Biegung aufweist (nicht dargestellt), um optimal auf die Hauptabstrahlrichtung der Antennenanordnung 11 ausgerichtet zu sein und die elektromagnetische Welle optimal zwischen dem Wellenleiter 2 und der Antennenanordnung 11 zu führen.

Figur 3 zeigt eine weitere Ausführung einer Leiterplattenbuchse 1 mit einem ungewinkelten Gehäuse, bestehend aus dem Sockel 1.1 und der Hülse 1.6. Im Gegensatz zu den vorhergehenden Ausführungsformen ist in der Ausführung der Figur 3 keine Versorgungsschaltung 12 vorgesehen. Ferner ist der Signalumsetzer 10 nicht an dem Sockel 1.1 sondern an der Leiterplatte 3 festgelegt. Dennoch sind die Antennenanordnung 11 des Signalumsetzers 10 und die Wellenführungsanordnung 6 optimal aufeinander ausgerichtet, da der Sockel 1.1 und der Signalumsetzer 10 jeweils fest definierte Positionen auf der Leiterplatte 3 einnehmen (diese können vorzugsweise durch das Lochraster bzw. die Löcher 4 bzw. Durchkontaktierungen der Leiterplatte 3 vorgegeben sein).

Exemplarisch ist in Figur 3 eine elektromagnetische Abschirmung 26 gezeigt, welche die Hülse 1.6 des Gehäuses wenigstens über einen Teil ihrer Länge, vorzugsweise über die gesamte Länge, umgibt. Eine derartige elektromagnetische Abschirmung 26 kann bei allen Ausführungsformen analog vorgesehen sein. Dies ist allerdings optional, verbessert jedoch die elektromagnetische Verträglichkeit des erfindungsgemäßen Steckverbinders. Die elektromagnetische Abschirmung 26 kann alternativ oder ergänzend zu der metallischen und/oder dielektrischen Abschirmung 1.5, welche bezüglich der Ausführungsform nach Figur 1 beschrieben wurde und die grundsätzlich bei allen Ausführungsformen ebenfalls eingesetzt werden könnte, Verwendung finden.

Die elektromagnetische Abschirmung 26 kann derart gestaltet sein, dass diese insbesondere die nicht elektrisch leitenden Teile des Gehäuses, insbesondere die Teile des Gehäuses, die nicht metallisch ausgebildet sind, umgibt. Grundsätzlich kann die elektromagnetische Abschirmung 26 aber auch derart gestaltet sein, dass das Gehäuse insgesamt, d. h. vorliegend der Sockel 1.1 und die Hülse 1.6, umfasst werden. Diese Ausgestaltung eignet sich insbesondere, wenn der Sockel 1.1 nicht bereits derart gestaltet ist, dass dieser eine elektromagnetische Abschirmung 26 gewährleistet, d. h. insbesondere wenn der Sockel 1.1 nicht aus Metall ausgebildet ist. Wenn das Gehäuse einteilig oder mehrteilig ausgebildet ist, kann die optional vorgesehene elektromagnetische Abschirmung 26 entsprechend angepasst sein.

Im Ausführungsbeispiel nach der Figur 3 ist die elektromagnetische Abschirmung 26 als Hülse aus einem elektrisch leitenden Material, im Ausführungsbeispiel Metall, ausgebildet. Die Hülse 26 ist dabei vorzugsweise elektrisch leitend mit einem "ground layer" der Leiterplatte 3 oder einem Massepunkt verbunden. Die Verbindung erfolgt im Ausführungsbeispiel dadurch, dass die Hülse 26 elektrisch leitend mit einem Sockel 1.1 verbunden ist. Der Sockel 1.1 des Gehäuses ist dabei vorzugsweise aus einem Zink-Druckguss hergestellt.

Eine elektromagnetische Abschirmung 26 lässt sich alternativ oder ergänzend zu einer Ausbildung einer Hülse vorzugsweise auch dadurch erreichen, dass die elektromagnetisch abzuschirmenden Gehäuseteile wenigstens teilweise, vorzugsweise vollständig, metallisch beschichtet sind. Dies kann vorzugsweise durch ein Aufdampfen erfolgen. Ferner kann die Hülse 1.6 und/oder der Sockel 1.1 auch mit einer Metallfolie versehen sein.

Eine elektromagnetische Abschirmung 26 lässt sich vorzugsweise auch dadurch erreichen, dass ein lediglich prinzipmäßig in der Figur 7 dargestellter Wellenleiter-Stecker 7 über eine Ausgestaltung verfügt, die geeignet ist, wenn der Wellenleiter-Stecker 7 mit dem erfindungsgemäßen Steckverbinder 1 verbunden ist, eine elektromagnetische Abschirmung für den erfindungsgemäßen Steckverbinder 1 bereitzustellen. Hierzu kann vorgesehen sein, dass der Wellenleiter-Stecker 7 wenigstens einen Teil des Gehäuses 1.1, 1.6 des erfindungsgemäßen Steckverbinders 1 entsprechend umgibt. Der Wellenleiter-Stecker 7 kann hierzu mit einer geeigneten elektromagnetischen Abschirmung, beispielsweise ausgeführt als Hülse, versehen sein. Vorgesehen ist dabei, dass die elektromagnetische Abschirmung des Wellenleiter-Steckers 7 vorzugsweise eine elektrisch leitende Verbindung zu einem Massepunkt bzw. einem "ground layer" der Leiterplatte 3 gegebenenfalls über den Sockel 1.1 herstellt. Hierzu können Kontaktfedern vorgesehen sein. Alternativ können auch andere bekannte Maßnahmen vorgesehen sein.

In Figur 4 ist eine Seitenansicht einer weiteren Leiterplattenbuchse 1 dargestellt. Dabei ist eine gewinkelte Gehäuseform (abermals mit einer Abwinklung von 90º) vorgesehen. Lediglich schematisch und gestrichelt sind innenliegend die Wellenführungsanordnung 6 und der Signalumsetzer 10 dargestellt. In der Variante der Figur 4 ist abermals keine Versorgungsschaltung 12 vorgesehen. Der Signalumsetzer 10 ist in dem Sockel 1.1 festgelegt. Die Hülse 1.6 weist einen Schnapphaken 14 auf. Seitliche Befestigungsmittel 1.2 sind an dem Sockel 1.1 vorgesehen. Ferner sind elektrische Kontakte 15 des Signalumsetzers 10 erkennbar, die zur Verbindung mit der Leiterplatte 3 dienen. Abstandsmittel 1.3 sorgen abermals dafür, dass der Sockel 1.1 nicht vollständig flach auf der Leiterplatte 3 aufliegt.

In Figur 5 ist eine weitere Ausführung der Erfindung dargestellt. Gezeigt ist eine Ausbildung des erfindungsgemäßen Steckverbinders als Kupplung 16 eines Koaxialkabels 17. Die erfindungsgemäße Kupplung 16 mit ihrem Gehäuse, das durch einen Sockel 16.1 und eine Hülse 16.3 gebildet ist, nimmt dabei das Koaxialkabel 17 auf und ist an diesem festgelegt. Das Koaxialkabel 17 umfasst einen elektrischen Innenleiter 17.1 sowie einen elektrischen Außenleiter 17.2, die durch ein Dielektrikum 17.3 separiert sind. Ein isolierender Außenmantel 17.4 umhüllt das Koaxialkabel 17. Als Befestigungsmittel ist eine Crimphülse 18 oder sonstige Befestigungsmittel vorgesehen, welche für eine ausreichende Fixierung des Koaxialkabels 17 an der Kupplung 16 sorgt bzw. sorgen. Vorliegend ist die Crimphülse 18 mit dem Koaxialkabel 17 in einem Verbindungsteil 16.2 aufgenommen. Das Verbindungsteil 16.2 weist somit das Koaxialkabel 17 mit den elektrischen Leitern 17.1, 17.2 auf und kann als die erfindungsgemäße Struktur bezeichnet werden. Das Verbindungsteil 16.2 dient vorliegend der verbesserten Befestigung des Koaxialkabels 17 an der Kupplung 16 und kann z. B. mit dem Sockel 16.1 verklebt sein. Das Koaxialkabel 17 kann aber auch direkt an dem Sockel 16.1 befestigt sein und stellt in diesem Fall die erfindungsgemäße Struktur dar.

Die Kupplung 16 umfasst einen Signalumsetzer 10, der mit einer Versorgungsschaltung 12 elektrisch und mechanisch verbunden ist. Die Versorgungsschaltung 12 ist mit dem Sockel 16.1 der Kupplung 16 verbunden bzw. an diesem festgelegt. Abermals ist eine Wellenführungsanordnung 6 auf eine Antennenanordnung 11 des Signalumsetzers 10 ausgerichtet. Der Sockel 16.1 und die Hülse 16.3 sind nicht gewinkelt ausgebildet, wobei die Einsteckrichtung 9 des Wellenleiters 2 parallel zu der Längsachse L_{K} des Koaxialkabels 17 verläuft. Der Signalumsetzer 10 und die Versorgungsschaltung 12 sind von dem Sockel 16.1 der Kupplung 16 vorzugsweise vollständig aufgenommen.

Im Ausführungsbeispiel ist ein einadriges Koaxialkabel 17 dargestellt. Es kann allerdings ein beliebiges Kabel mit einer beliebigen Anzahl Innenleiter vorgesehen sein.

Eine elektrische Versorgung des Signalumsetzers 10 und/oder der Versorgungsschaltung 12 kann über wenigstens einen der elektrischen Leiter, vorliegend den Innenleiter 17.1 und den Außenleiter 17.2 des Koaxialkabels 17, vorgesehen sein, wobei das Koaxialkabel 17 auch wenigstens eines der elektrischen Signale überträgt.

Eine weitere Ausführung des erfindungsgemäßen Steckverbinders zeigt Figur 6. In Figur 6 ist der erfindungsgemäße Steckverbinder als Adapter 19 ausgebildet. Das Gehäuse des Adapters 19, das durch einen Sockel 19.1 und eine Hülse 19.5 gebildet ist, weist Befestigungsmittel 19.2 zur Festlegung des Adapters 19 an einem Koaxialstecker (nicht dargestellt) auf. Der Adapter 19 umfasst einerseits ein Buchsenteil 19.3 für einen herkömmlichen elektrischen Koaxialstecker und andererseits ein Buchsenteil 19.4 zur Verbindung mit einem Wellenleiter-Stecker 7 oder einem beliebigen Anschluss für eine Wellenführung 2. Selbstverständlich kann durch den erfindungsgemäßen Adapter auch eine Adaptierung eines beliebigen elektrischen Steckverbinders auf einen beliebigen Wellenleiter-Steckverbinder vorgesehen sein.

Figur 7 zeigt ein System 20 zur Übertragung von hochfrequenten elektromagnetischen Signalen. Das System 20 umfasst eine erste Signalverarbeitungseinheit 21, eine zweite Signalverarbeitungseinheit 22 und einen Wellenleiter 2. Zwischen den beiden Signalverarbeitungseinheiten 21, 22 ist ein hochfrequentes elektromagnetisches Signal über den Wellenleiter 2 übertragbar. In dem Wellenleiter 2 ist eine einzelne Wellenführung 2.1 gestrichelt angedeutet.

Die Signalverarbeitungseinheiten 21, 22 umfassen jeweils einen Steckverbinder 1, 24 gemäß der vorstehenden Beschreibung und eine Struktur 3, 25, die wenigstens einen elektrischen Leiter (nicht dargestellt) aufweist.

Bei dem ersten Steckverbinder 21 handelt es sich um eine Leiterplattenbuchse 1, die auf einer Leiterplatte 3 angeordnet ist, wobei die Leiterplatte 3 wenigstens eine integrierte Schaltung und/oder wenigstens ein diskretes elektrisches Bauelement 23 aufweist. Beispielhaft sind zwei diskrete elektrische Bauelemente 23 als SMD-Bauelemente dargestellt. Die Leiterplattenbuchse 1 bzw. das Gehäuse 1.1, 1.6 der Leiterplattenbuchse 1 ist mit Befestigungsmitteln 1.2 ausgestattet, die durch die Leiterplatte 3 hindurchgesteckt werden können und rückseitig an der Leiterplatte 3 verlötet sind.

Die zweite Signalverarbeitungseinheit 22 umfasst eine Einbaubuchse 24, die in oder an einem Gerätegehäuse 25 eines elektrischen Geräts bzw. dem Gerätegehäuse 25 der zweiten Signalverarbeitungseinheit 22 festgelegt ist.

Es kann vorgesehen sein, dass ein Signalumsetzer 10 auf der Struktur 3, 25, die den wenigstens einen elektrischen Leiter aufweist, festgelegt ist und in dem Gehäuse 1.1, 1.6 bzw. 24.1, 24.2 des Steckverbinders 1, 24 aufgenommen ist, wenn der Steckverbinder 1, 24 auf der Struktur 3, 25 festgelegt ist. Alternativ kann der Signalumsetzer 10 auch in dem Gehäuse 1.1, 1.6 bzw. 24.1, 24.2 festgelegt oder Bestandteil des Gehäuses 1.1, 1.6 bzw. 24.1, 24.2 sein.

Figur 8 zeigt einen Querschnitt eines dielektrischen Wellenleiters 2, der zur räumlich separierten Mehrkanalübertragung ausgebildet ist. Der Wellenleiter 2 weist hierfür zwei parallel verlaufende dielektrische Wellenführungen 2.1 auf, die sich über die Länge des Wellenleiters 2 durch einen dielektrischen Mantel 2.3 erstrecken. Der dielektrische Mantel kann auch als dielektrische Hülle verstanden werden. Der dielektrischen Mantel 2.3 weist eine geringere Dielektrizitätszahl auf, als die dielektrischen Wellenführungen 2.1. Optional kann eine metallische oder sonstige Abschirmung zwischen den Wellenführungen 2.1 vorgesehen sein. Es kann auch eine weitere Ummantelung und/oder eine sonstige Abschirmung vorgesehen sein, die den Wellenleiter 2 bzw. dessen dielektrischen Mantel 2.3 umhüllt.

Die Figur 9 zeigt einen Wellenleiter 2', der als dielektrisches Wellenleiterkabel ausgebildet ist. Der Wellenleiter 2' umfasst einen dielektrischen Kern 2.1 zur Übertragung einer elektromagnetischen Welle, eine dielektrische Hülle 2.2 zur Schirmung der zu übertragenden Welle und einen dielektrischen Mantel 2.3 zum Schutz des dielektrischen Wellenleiters 2'.

In Figur 9 kann der dielektrische Kern 2.1 in einer bevorzugten Ausgestaltung aus Polyethylen (PE) und/oder Polypropylen (PP) und/oder Polytetrafluorethylen (PTFE) ausgebildet sein. Bevorzugt weist der Kern 2.1 einen runden Querschnitt auf, wobei auch andere Formen vorgesehen sein können. Den dielektrischen Kern 2.1 konzentrisch umgebend ist in Figur 9 eine dielektrische Hülle 2.2 vorzugsweise aus PE-Schaum ausgebildet. Anstelle eines PE-Schaums eignen sich auch PTFE-Bänder in besonderem Maße. Auch hier sind andere Gestaltungen, insbesondere aus den anderen vorgenannten Materialien möglich. Der Schaum ist vorzugsweise derart ausgelegt, dass dieser geeignet ist, bei ausreichender mechanischer Stabilität möglichst viel Luft in die dielektrische Hülle 2.2 einzulagern.

In der Ausführungsform nach Figur 9 kann vorzugsweise ferner vorgesehen sein, dass die dielektrische Hülle 2.2, wie dargestellt, konzentrisch von dem dielektrischen Mantel 2.3 umgeben ist, wobei der dielektrische Mantel 2.3 vorzugsweise aus TPE (thermoplastisches Elastomer), insbesondere TPE S, ausgebildet ist. TPE bzw. TEP S ist ein Dielektrikum mit besonders großen Flussfaktoren sowie vorteilhaften mechanischen Eigenschaften, besonders hinsichtlich der Festigkeit gegen Abknicken. Ferner weist TPE bzw. TPE S eine hohe Flammbeständigkeit auf. Der dielektrische Mantel 2.3 stellt vorzugsweise einen Schutz sowohl vor UV-Strahlung als auch vor mechanischen Einflüssen bereit.

Es sei darauf hingewiesen, dass die vorgenannten Materialien für den dielektrischen Kern 2.1, die dielektrische Hülle 2.2 und den dielektrischen Mantel 2.3 beispielhaft sind, es können hier auch beliebige andere geeignete Materialien zum Einsatz kommen, insbesondere sind auch dielektrische Wellenleiterkabel, wie LWL oder POF, zur optischen Übertragung von Signalen bekannt. Derartige Kabel weisen in der Regel Quarzglas oder PMMA (Polymethylmethacrylat) auf.

Der dielektrische Kern 2.1 kann auch über eine nicht näher dargestellte Bohrung, die vorzugsweise mittig eingebracht ist, verfügen. Es ist jedoch auch denkbar, die Bohrung nicht symmetrisch zu dem dielektrischen Kern 2.1 anzuordnen. Weiterhin ist es denkbar, mehrere Bohrungen in dem dielektrischen Kern 2.1 auszubilden. Die Bohrung kann den dielektrischen Kern 2.1 auch ersetzen.

Die Erfindung ist nicht auf die Verwendung eines spezifischen Wellenleiters 2, 2' bzw. eines Wellenleiterkabels beschränkt. Entsprechend sind auch die Ausführungsbeispiele zu verstehen.

## Patentansprüche

1. Steckverbinder (1, 16, 19, 24) zur Verbindung eines Wellenleiters (2, 2') mit wenigstens einem elektrischen Leiter (17.1, 17.2), mit einem Gehäuse (1.1, 1.6, 16.1, 16.3, 19.1, 19.5, 24.1, 24.2) zur Verbindung mit dem Wellenleiter (2, 2'), wobei Befestigungsmittel (1.2, 18, 19.2) zur Festlegung des Gehäuses (1.1, 1.6, 16.1, 16.3, 19.1, 19.5, 24.1, 24.2) an einer Struktur (3, 17, 25), die den wenigstens einen elektrischen Leiter (17.1, 17.2) aufweist, vorgesehen sind, **dadurch gekennzeichnet, dass** das Gehäuse (1.1, 1.6, 16.1, 16.3, 19.1, 19.5, 24.1, 24.2) eingerichtet ist, einen Signalumsetzer (10) mit einer Antennenanordnung (11) aufzunehmen, wobei innerhalb des Gehäuses (1.1, 1.6, 16.1, 16.3, 19.1, 19.5, 24.1, 24.2), welches hierfür eingerichtet ist, eine Wellenführungsanordnung (6) vorgesehen ist, wobei die Wellenführungsanordnung (6) zur Führung einer elektromagnetischen Welle in den Wellenleiter (2, 2') und zur Kopplung mit der Antennenanordnung (11) angeordnet und ausgebildet ist, und wobei der Signalumsetzer (10) mit dem wenigstens einen elektrischen Leiter (17.1, 17.2) verbunden ist und eingerichtet ist, um eine Wandlung zwischen elektrischen Signalen und hochfrequenten elektromagnetischen Signalen durchzuführen, wobei der Signalumsetzer (10) als Bestandteil des Steckverbinders (1, 16, 19, 24) in dem Gehäuse (1.1, 1.6, 16.1, 16.3, 19.1, 19.5, 24.1, 24.2) festgelegt ist.

2. Steckverbinder (1, 16, 19, 24) nach Anspruch 1,
**dadurch gekennzeichnet, dass**
der Steckverbinder als Leiterplattensteckverbinder, vorzugsweise als Leiterplattenbuchse (1), und die Struktur, die den wenigstens einen elektrischen Leiter aufweist, als Leiterplatte (3) ausgebildet ist.

3. Steckverbinder (1, 16, 19, 24) nach Anspruch 1,
**dadurch gekennzeichnet, dass**
der Steckverbinder als Stecker oder Kupplung (16), und die Struktur, die den wenigstens einen elektrischen Leiter (17.1, 17.2) aufweist, als Kabel, vorzugsweise als Koaxialkabel (17), ausgebildet ist.

4. Steckverbinder (1, 16, 19, 24) nach Anspruch 1,
**dadurch gekennzeichnet, dass**
der Steckverbinder als Adapter (19), und die Struktur, die den wenigstens einen elektrischen Leiter aufweist, als elektrischer Steckverbinder, vorzugsweise als Koaxialsteckverbinder, ausgebildet ist.

5. Steckverbinder (1, 16, 19, 24) nach einem der Ansprüche 1 bis4,
**dadurch gekennzeichnet, dass**
der Signalumsetzer (10) wenigstens eine integrierte Schaltung und/oder wenigstens eine Signalplatine und/oder wenigstens ein diskretes elektrisches Bauelement aufweist.

6. Steckverbinder (1, 16, 19, 24) nach einem der Ansprüche 1 bis5,
**dadurch gekennzeichnet, dass**
eine Versorgungsschaltung (12) für den Signalumsetzer (10) als Bestandteil des Steckverbinders (1, 16, 19, 24) in dem Gehäuse (1.1, 1.6, 16.1, 16.3, 19.1, 19.5, 24.1, 24.2) festgelegt ist, wobei die Versorgungsschaltung (12) wenigstens eine integrierte Schaltung und/oder wenigstens eine Versorgungsplatine und/oder wenigstens ein diskretes elektrisches Bauelement aufweist.

7. Steckverbinder (1, 16, 19, 24) nach einem der Ansprüche 1 bis6,
**dadurch gekennzeichnet, dass**
die Wellenführungsanordnung (6) zur Führung der elektromagnetischen Welle als Teil des Steckverbinders (1, 16, 19, 24) ausgebildet ist oder die Wellenführungsanordnung (6) als Teil des ein- oder mehrteiligen Wellenleiters (2, 2') ausgebildet und mit dem Gehäuse (1.1, 1.6, 16.1, 16.3, 19.1, 19.5, 24.1, 24.2) lösbar oder unlösbar verbunden ist.

8. Steckverbinder (1, 16, 19, 24) nach einem der Ansprüche 1 bis7,
**dadurch gekennzeichnet, dass**
das Gehäuse (1.1, 16.1, 19.1, 24.1) derart ausgebildet ist, dass eine Einsteckrichtung (9) des Wellenleiters (2) gegenüber einer Orthogonalen (L) zu einer Auflagefläche (A) des Gehäuses (1.1, 1.6, 16.1, 16.3, 19.1, 19.5, 24.1, 24.2) auf der Struktur (3, 17, 25) um 1º bis 90º, beispielsweise 10°bis 80°, 20° bis 70°, 30° bis 60° oder 40° bis 50°, vorzugsweise 45º oder 90º, geneigt ist.

9. Steckverbinder (1, 16, 19, 24) nach einem der Ansprüche 1 bis8,
**dadurch gekennzeichnet, dass**
die Wellenführungsanordnung (6) im Gehäuse (1.1, 1.6, 16.1, 16.3, 19.1, 19.5, 24.1, 24.2) zur Ausrichtung auf eine Hauptabstrahlrichtung der Antennenanordnung (11) gewinkelt ausgebildet ist und beispielsweise eine Biegung zwischen 1° bis 90°, 10° bis 80°, 20° bis 70°, 30° bis 60° oder 40° bis 50°, vorzugsweise von 45º oder 90º, aufweist.

10. Steckverbinder (1, 16, 19, 24) nach einem der Ansprüche 1 bis9,
**dadurch gekennzeichnet, dass**
das Gehäuse (1.1, 1.6, 16.1, 16.3, 19.1, 19.5, 24.1, 24.2) des Steckverbinders (1, 16, 19, 24) zur Reduzierung oder Aufhebung der elektromagnetischen Abstrahlung wenigstens teilweise von einer elektromagnetischen Abschirmung (26) umgeben ist.

11. Steckverbinder (1, 16, 19, 24) nach einem der Ansprüche 1 bis10,
**dadurch gekennzeichnet, dass**
eine elektrische Versorgung des Signalumsetzers (10) über wenigstens einen der elektrischen Leiter (17.1, 17.2) vorgesehen ist, der auch wenigstens eines der elektrischen Signale überträgt.

12. Signalverarbeitungseinheit (21, 22) mit einem Steckverbinder (1, 16, 19, 24) gemäß einem der Ansprüche 1 bis 11 und mit einer Struktur (3, 17, 25), die wenigstens einen elektrischen Leiter (17.1, 17.2) aufweist.

13. Signalverarbeitungseinheit (21, 22) nach Anspruch12,
**dadurch gekennzeichnet, dass**
ein Signalumsetzer (10) auf der Struktur (3, 17, 25) festgelegt und in einem Gehäuse (1.1, 1.6, 16.1, 16.3, 19.1, 19.5, 24.1, 24.2) des Steckverbinders (1, 16, 19, 24) aufgenommen ist, wenn der Steckverbinder (1, 16, 19, 24) auf der Struktur (3, 17, 25) festgelegt ist.

14. System (20) zur Übertragung von hochfrequenten elektromagnetischen Signalen, umfassend
- eine erste Signalverarbeitungseinheit (21) gemäß einem der Ansprüche 12 oder13,
- eine zweite Signalverarbeitungseinheit (22) mit einem zweiten Steckverbinder, und
- einen Wellenleiter (2, 2'),
wobei wenigstens ein hochfrequentes elektromagnetisches Signal zwischen den beiden Signalverarbeitungseinheiten (21, 22) über den Wellenleiter (2, 2') übertragbar ist.

## Claims

1. Plug connector (1, 16, 19, 24) for connecting a waveguide (2, 2') to at least one electrical conductor (17.1, 17.2), having a housing (1.1, 1.6, 16.1, 16.3, 19.1, 19.5, 24.1, 24.2) for connection to the waveguide (2, 2'), wherein fastening means (1.2, 18, 19.2) are provided for the purpose of fixing the housing (1.1, 1.6, 16.1, 16.3, 19.1, 19.5, 24.1, 24.2) to a structure (3, 17, 25) having the at least one electrical conductor (17.1, 17.2),
**characterized in that**
the housing (1.1, 1.6, 16.1, 16.3, 19.1, 19.5, 24.1, 24.2) is set up to accommodate a signal converter (10) having an antenna arrangement (11), wherein a waveguiding arrangement (6) is provided inside the housing (1.1, 1.6, 16.1, 16.3, 19.1, 19.5, 24.1, 24.2) which is set up for this purpose, wherein the waveguiding arrangement (6) is arranged and designed for the purpose of guiding an electromagnetic wave into the waveguide (2, 2') and for coupling to the antenna arrangement (11), and wherein the signal converter (10) is connected to the at least one electrical conductor (17.1, 17.2) and is set up to carry out conversion between electrical signals and high-frequency electromagnetic signals, wherein the signal converter (10), as part of the plug connector (1, 16, 19, 24), is fixed in the housing (1.1, 1.6, 16.1, 16.3, 19.1, 19.5, 24.1, 24.2).

2. Plug connector (1, 16, 19, 24) according to Claim 1,
**characterized in that**
the plug connector is in the form of a printed circuit board plug connector, preferably in the form of a printed circuit board jack (1), and the structure having the at least one electrical conductor is in the form of a printed circuit board (3).

3. Plug connector (1, 16, 19, 24) according to Claim 1,
**characterized in that**
the plug connector is in the form of a plug or coupling (16), and the structure having the at least one electrical conductor (17.1, 17.2) is in the form of a cable, preferably in the form of a coaxial cable (17).

4. Plug connector (1, 16, 19, 24) according to Claim 1,
**characterized in that**
the plug connector is in the form of an adapter (19), and the structure having the at least one electrical conductor is in the form of an electrical plug connector, preferably in the form of a coaxial plug connector.

5. Plug connector (1, 16, 19, 24) according to one of Claims 1 to 4,
**characterized in that**
the signal converter (10) has at least one integrated circuit and/or at least one signal circuit board and/or at least one discrete electrical component.

6. Plug connector (1, 16, 19, 24) according to one of Claims 1 to 5,
**characterized in that**
a supply circuit (12) for the signal converter (10), as part of the plug connector (1, 16, 19, 24), is fixed in the housing (1.1, 1.6, 16.1, 16.3, 19.1, 19.5, 24.1, 24.2), wherein the supply circuit (12) has at least one integrated circuit and/or at least one supply circuit board and/or at least one discrete electrical component.

7. Plug connector (1, 16, 19, 24) according to one of Claims 1 to 6,
**characterized in that**
the waveguiding arrangement (6) for guiding the electromagnetic wave is designed as part of the plug connector (1, 16, 19, 24), or the waveguiding arrangement (6) is designed as part of the one-part or multi-part waveguide (2, 2') and is connected to the housing (1.1, 1.6, 16.1, 16.3, 19.1, 19.5, 24.1, 24.2) in a releasable or non-releasable manner.

8. Plug connector (1, 16, 19, 24) according to one of Claims 1 to 7,
**characterized in that**
the housing (1.1, 16.1, 19.1, 24.1) is designed in such a manner that an insertion direction (9) of the waveguide (2) is inclined with respect to an orthogonal (L) with respect to a contact area (A) of the housing (1.1, 1.6, 16.1, 16.3, 19.1, 19.5, 24.1, 24.2) on the structure (3, 17, 25) by 1° to 90°, for example 10° to 80°, 20° to 70°, 30° to 60° or 40° to 50°, preferably 45° or 90°.

9. Plug connector (1, 16, 19, 24) according to one of Claims 1 to 8,
**characterized in that**
the waveguiding arrangement (6) in the housing (1.1, 1.6, 16.1, 16.3, 19.1, 19.5, 24.1, 24.2) is designed in an angled manner for alignment with a main radiation direction of the antenna arrangement (11) and, for example, has a curvature of between 1° and 90°, 10° and 80°, 20° and 70°, 30° and 60° or 40° and 50°, preferably of 45° or 90 °.

10. Plug connector (1, 16, 19, 24) according to one of Claims 1 to 9,
**characterized in that**
the housing (1.1, 1.6, 16.1, 16.3, 19.1, 19.5, 24.1, 24.2) of the plug connector (1, 16, 19, 24) is at least partially surrounded by an electromagnetic screen (26) for the purpose of reducing or cancelling the electromagnetic radiation.

11. Plug connector (1, 16, 19, 24) according to one of Claims 1 to 10,
**characterized in that**
the signal converter (10) is electrically supplied via at least one of the electrical conductors (17.1, 17.2) which also transmits at least one of the electrical signals.

12. Signal processing unit (21, 22) having a plug connector (1, 16, 19, 24) according to one of Claims 1 to 11 and having a structure (3, 17, 25) which has at least one electrical conductor (17.1, 17.2).

13. Signal processing unit (21, 22) according to Claim 12,
**characterized in that**
a signal converter (10) is fixed on the structure (3, 17, 25) and is accommodated in a housing (1.1, 1.6, 16.1, 16.3, 19.1, 19.5, 24.1, 24.2) of the plug connector (1, 16, 19, 24) when the plug connector (1, 16, 19, 24) is fixed on the structure (3, 17, 25).

14. System (20) for transmitting high-frequency electromagnetic signals, comprising
- a first signal processing unit (21) according to either of Claims 12 and 13,
- a second signal processing unit (22) having a second plug connector, and
- a waveguide (2, 2'),
wherein at least one high-frequency electromagnetic signal can be transmitted between the two signal processing units (21, 22) via the waveguide (2, 2').

## Revendications

1. Connecteur enfichable (1, 16, 19, 24) destiné à relier un conducteur d'ondes (2, 2') à au moins un conducteur électrique (17.1, 17.2), avec un boîtier (1.1, 1.6, 16.1, 16.3, 19.1, 19.5, 24.1, 24.2) pour assurer le raccordement avec le conducteur d'ondes (2, 2'), dans lequel des moyens de fixation (1.2, 18, 19.2) pour fixer le boîtier (1.1, 1.6, 16.1,16.3, 19.1, 19.5, 24.1, 24.2) à une structure (3, 17, 25), qui comporte ledit au moins un conducteur électrique (17.1, 17.2), sont prévus,
**caractérisé en ce qu'**
un boîtier (1.1, 1.6, 16.1, 16.3, 19.1, 19.5, 24.1, 24.2) est agencé pour prendre en charge un transformateur de signal (10) avec une installation d'antenne (11), dans lequel à l'intérieur du boîtier (1.1, 1.6, 16.1, 16.3, 19.1, 19.5, 24.1, 24.2), qui est aménagé en conséquence, est disposée une installation de guidage d'ondes (6), dans lequel l'installation de guidage d'ondes (6) est disposée et aménagée pour guider une onde électromagnétique dans le conducteur d'ondes (2, 2') et assurer le couplage avec l'installation d'antenne (11), et dans lequel le transformateur de signal (10) avec ledit au moins un conducteur électrique (17.1, 17.2) est relié et installé pour effectuer une transformation entre des signaux électriques et des signaux électromagnétiques de haute fréquence, dans lequel le transformateur de signal (10) est défini comme élément constitutif du connecteur enfichable (1, 16, 19, 24) dans le boîtier (1.1, 1.6, 16.1,16.3, 19.1, 19.5, 24.1, 24.2).

2. Connecteur enfichable (1, 16, 19, 24) selon la revendication 1, **caractérisé en ce que**
le connecteur enfichable se présente sous la forme d'un connecteur de carte de circuit imprimé, de préférence d'une prise de carte à circuit imprimé (1), et la structure, qui comporte ledit au moins un conducteur électrique, est constituée d'une carte à circuit imprimé (3).

3. Connecteur enfichable (1, 16, 19, 24) selon la revendication 1, **caractérisé en ce que**
le connecteur enfichable est une fiche ou un couplage (16), et la structure, qui comporte ledit au moins un conducteur électrique (17.1, 17.2) est constituée d'un câble, de préférence d'un câble coaxial (17).

4. Connecteur enfichable (1, 16, 19, 24) selon la revendication 1, **caractérisé en ce que**,
le connecteur enfichable est un adaptateur (19), et la structure, qui comporte ledit au moins un conducteur électrique, est constituée d'un connecteur enfichable électrique, de préférence d'un connecteur enfichable coaxial.

5. Connecteur enfichable (1, 16, 19, 24) selon l'une des revendications 1 à 4,
**caractérisé en ce que**
le transformateur de signal (10) comporte au moins une prise intégrée et/ou au moins une plaque de signal et/ou au moins un élément de construction électrique discret.

6. Connecteur enfichable (1, 16, 19, 24) selon l'une des revendications 1 à 5,
**caractérisé en ce qu'**
un circuit d'alimentation (12) pour le transformateur de signal (10) est défini comme faisant partie du connecteur enfichable (1, 16, 19, 24) fixé dans le boîtier (1.1, 1.6, 16.1, 16.3, 19.1, 19.5, 24.1, 24.2), dans lequel le circuit d'alimentation (12) comporte au moins une prise intégrée et/ou au moins une plaque de signal et/ou au moins un élément de construction électrique discret.

7. Connecteur enfichable (1, 16, 19, 24) selon l'une des revendications 1 à 6,
**caractérisé en ce que**
l'installation de guidage d'ondes (6) pour guider l'onde électromagnétique est formée comme une partie du connecteur enfichable (1, 16, 19, 24) ou que l'installation de guidage d'ondes (6), est formée comme une partie du conducteur d'ondes en une ou plusieurs parties (2, 2') et est connectée de façon amovible ou permanente au boîtier (1.1, 1.6, 16.1, 16.3, 19.1, 19.5, 24.1, 24.2).

8. Connecteur enfichable (1, 16, 19, 24) selon l'une des revendications 1 à 7,
**caractérisé en ce que**
le boîtier (1.1, 16.1, 19.1, 24.1) est agencé de telle manière que l'installation de connexion (9) du conducteur d'ondes (2) est inclinée par rapport à une orthogonale (L) par rapport à une surface d'appui (A) du boîtier (1.1, 1.6, 16.1, 16.3, 19.1, 19.5, 24.1, 24.2) sur la structure (3, 17, 25) de 1° à 90°, par exemple de 10° à 80°, de 20° à 70°, de 30° à 60° ou de 40° à 50°, de préférence de 45° à 90°.

9. Connecteur enfichable (1, 16, 19, 24) selon l'une des revendications 1 à 8,
**caractérisé en ce que**
l'installation de guidage d'ondes (6), dans le boîtier (1.1, 1.6, 16.1, 16.3, 19.1, 19.5, 24.1, 24.2) pour l'orientation sur une installation de balayage principal de l'installation d'antenne (11) est réalisée de manière angulairement orientée, et présente par exemple une inclinaison comprise entre 1° à 90°, 10° à 80°, 20° à 70°, 30° à 60° ou 40° à 45°, de préférence de 45° à 90 °.

10. Connecteur enfichable (1, 16, 19, 24) selon l'une des revendications 1 à 9,
**caractérisé en ce que**
le boîtier (1.1, 1.6, 16.1, 16.3, 19.1, 19.5, 24.1, 24.2) du connecteur enfichable (1, 16, 19, 24) pour réduire ou augmenter le rayonnement électromagnétique est au moins partiellement entouré d'une protection électromagnétique (26).

11. Connecteur enfichable (1, 16, 19, 24) selon l'une des revendications 1 à 10,
**caractérisé en ce qu'**
une alimentation électrique du transformateur de signal (10) est fournie par au moins un des conducteurs électriques (17.1, 17.2), qui transmet également au moins l'un des signaux électriques.

12. Unité de traitement de signal (21, 22) avec un connecteur enfichable (1, 16, 19, 24) selon l'une des revendications 1 à 11 et avec une structure (3, 17, 25) qui comporte au moins un conducteur électrique (17.1, 17.2).

13. Unité de traitement de signal (21, 22) selon la revendication 12,
**caractérisé en ce que**
le transformateur de signal (10) est fixé sur la structure (3, 17, 25) et inclus dans un boîtier (1.1, 1.6, 16.1, 16.3, 19.1, 19.5, 24.1, 24.2) du connecteur enfichable (1, 16, 19, 24), lorsque le connecteur enfichable (1, 16, 19, 24), est fixé sur la structure (3, 17, 25).

14. Système (20) pour la transmission de signaux électromagnétiques de haute fréquence, comprenant
- une première unité de traitement de signal (21) selon l'une des revendications 12 ou 13,
- une seconde unité de traitement du signal (22) avec un second connecteur enfichable, et
- un conducteur d'ondes (2, 2'),
dans lequel au moins un signal électromagnétique de haute fréquence entre les deux unités de traitement de signaux (21, 22) est transférable via le conducteur d'ondes (2, 2').
